(19) Europäisches Patentamt

European Patent Office

Office européen des brevets

(11) **EP 4 339 628 B1**

(12) **EUROPEAN PATENT SPECIFICATION**

(45) Date of publication and mention of the grant of the patent:
**18.12.2024 Bulletin 2024/51**

(21) Application number: **23194464.6**

(22) Date of filing: **31.08.2023**

(51) International Patent Classification (IPC):
**G01R 27/26** (2006.01)

(52) Cooperative Patent Classification (CPC):
**G01R 27/2605**

(54) **MEASUREMENT SYSTEM, RELATED INTEGRATED CIRCUIT AND METHOD**

MESSSYSTEM, ZUGEHÖRIGE INTEGRIERTE SCHALTUNG UND VERFAHREN

SYSTÈME DE MESURE, CIRCUIT INTÉGRÉ ET PROCÉDÉ ASSOCIÉS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **19.09.2022 IT 202200019113**

(43) Date of publication of application:
**20.03.2024 Bulletin 2024/12**

(73) Proprietor: **STMicroelectronics S.r.l.**
**20864 Agrate Brianza (MB) (IT)**

(72) Inventors:
- **NICOLLINI, Germano**
**29121 Piacenza (IT)**
- **VAIANA, Michele**
**95037 San Giovanni La Punta (Catania) (IT)**

(74) Representative: **Buzzi, Notaro & Antonielli d'Oulx S.p.A.**
**Corso Vittorio Emanuele II, 6**
**10123 Torino (IT)**

(56) References cited:
**US-A1- 2014 372 057     US-A1- 2015 362 541**

- **NABOVATI GHAZAL ET AL: "Novel DC-input [Sigma][Delta] capacitance-to-digital convertor for biosensor appl", 2014 IEEE 12TH INTERNATIONAL NEW CIRCUITS AND SYSTEMS CONFERENCE (NEWCAS), IEEE, 22 June 2014 (2014-06-22), pages 89 - 92, XP032668015, DOI: 10.1109/NEWCAS.2014.6933992**
- **PRAKASH S B ET AL: "A Fully Differential Rail-to-Rail CMOS Capacitance Sensor With Floating-Gate Trimming for Mismatch Compensation", IEEE TRANSACTIONS ON CIRCUITS AND SYSTEMS I: REGULAR PAPERS, IEEE, US, vol. 56, no. 5, 1 May 2009 (2009-05-01), pages 975 - 986, XP011333422, ISSN: 1549-8328, DOI: 10.1109/TCSI.2009.2015202**

EP 4 339 628 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical field

The embodiments of the present description refer measurement systems, such as capacitive sensors.

Background

Capacitive sensors are commonly used. For example, such capacitive sensor may have a high resolution, low complexity and low temperature-dependency. For example, such capacitive sensors may be used in microelectromechanical systems (MEMS) based sensors, such as accelerometers, position sensors, pressure sensors, and moisture sensors. Recently, such capacitive sensors have also been used for Laboratory on a Chip (LoC) applications, e.g., for DNA protein interaction quantification, cellular monitoring, bio-particle detection, organic solvent monitoring, sensing of droplet parameters, bacteria detection, etc.

In general, a capacitive sensor comprises at least one couple of sensing electrodes that are connected to an interface readout circuit.

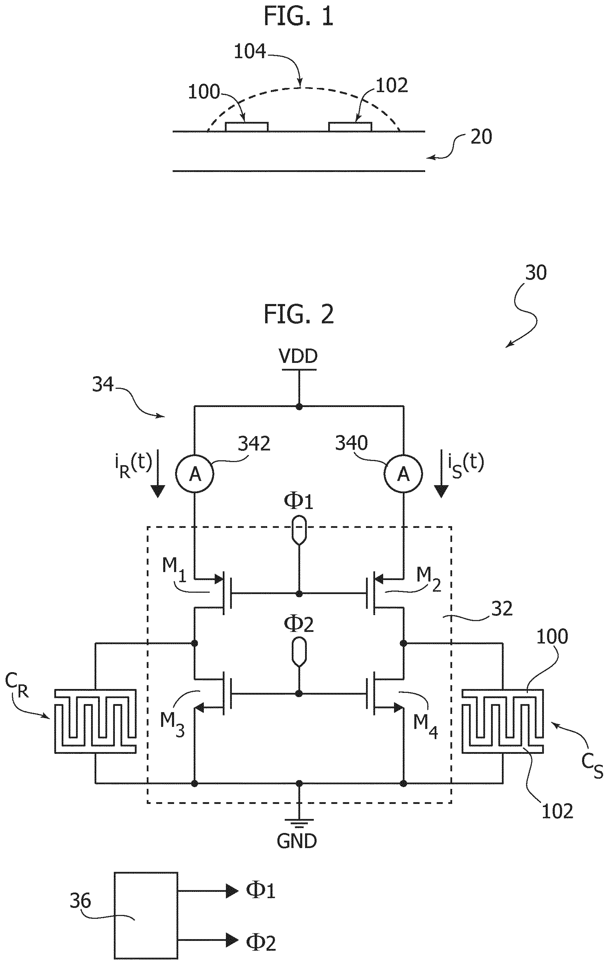

For example, Figure 1 shows a typical LoC application, wherein two electrodes 100 and 102 implemented with a conductive material, are arranged on an integrated circuit 20. In a capacitive sensor, the electrodes 100 and 102 are connected to an interface circuit, e.g., implemented within the integrated circuit 20, which is configured to generate an analog or digital signal by measuring a value being indicative of the capacitance value between the electrodes 100 and 102.

Accordingly, in case the physical, biological and/or chemical properties of a sample 104 in the vicinity of the electrodes 100 and 102 influence the capacitance of the capacitor formed by the electrodes 100 and 102, a processing circuit, e.g., implemented within the integrated circuit 20, may be configured to provide an estimate of the physical, biological and/or chemical properties of the sample 104 as a function of the measured capacitance value.

In this respect the Complementary Metal-Oxide-Semiconductor (CMOS) technology offers great advantages for the development of capacitive sensors, e.g., because it permits to implement highly integrated circuits with low costs. This permits also to achieve a higher sensitivity and a rapid detection, and to integrate the electrical readout circuit and/or the sensing electrodes on a single chip 20. Those of skill in the art will appreciate that various CMOS capacitive sensing techniques have been proposed in literature for different LoC applications. One of the most commonly used technique is the charge-based capacitance measurement (CBCM). For example, the CBCM technique is described in document James C. Chen, Bruce W. McGaughy, Dennis Sylvester, and Chenming Hu, "An On-Chip, Attofarad Interconnect Charge-Based Capacitance Measurement (CBCM) Technique", International Electron Devices Meeting (IEDM) 1996, or United States Patent Application n. US 2003/0218473 A1. A biosensor CBCM circuit is taught in the IEEE paper "Novel DC-input [Sigma] [Delta] capacitance-to-digital convertor for biosensor appl", by Nabovati, IEEE 2014 NEWCAS conf., p. 89-92, XP032668015.

Figure 2 shows an example of an interface circuit 30 according to the CBCM technique.

As mentioned before, the electrodes 100 and 102 form a sense capacitance/capacitor Cs, wherein the capacitance value of the sense capacitance $C_S$ is usually indicative of the physical, biological and/or chemical properties of a sample 104 in the vicinity of the electrodes 100 and 102.

Specifically, in the example considered, the current path of a first electronic switch $M_4$, such as a transistor, such as an n-channel Field-effect transistor (FET), such as an n-channel Metal-Oxide-Semiconductor (MOS) FET, is connected (e.g., directly) in parallel with the sense capacitance Cs, i.e., the electronic switch $M_4$ is connected between the electrodes 100 and 102, and is thus configured to selectively short-circuit the sense capacitance $C_S$ as a function of a control signal $\Phi_2$ received at a control terminal of the electronic switch $M_4$, e.g., the gate terminal of a corresponding FET.

Moreover, the interface circuit comprises a second electronic switch $M_2$, such as a transistor, such as an p-channel Field-effect transistor (FET), such as an p-channel MOSFET, configured to selectively connect the sense capacitance $C_S$ to a supply voltage VDD as a function of a control signal $\Phi_1$ received at a control terminal of the electronic switch $M_2$, e.g., the gate terminal of a corresponding FET. For example, in the example considered, the electrode 102 of the capacitance $C_S$ is connected to a first reference voltage, e.g., ground GND, and the electrode 100 is connected via the electronic switch $M_2$ to a second reference voltage, e.g., a supply voltage VDD of the integrated circuit 20. Accordingly, when the electronic switch $M_4$ is opened, the electronic switch $M_2$ may be used to selectively charge the sense capacitance $C_S$. Accordingly, a control circuit 36 may be configured to generate the control signals $\Phi_1$ and $\Phi_2$ in order to selectively charge and discharge the sense capacitance $C_S$.

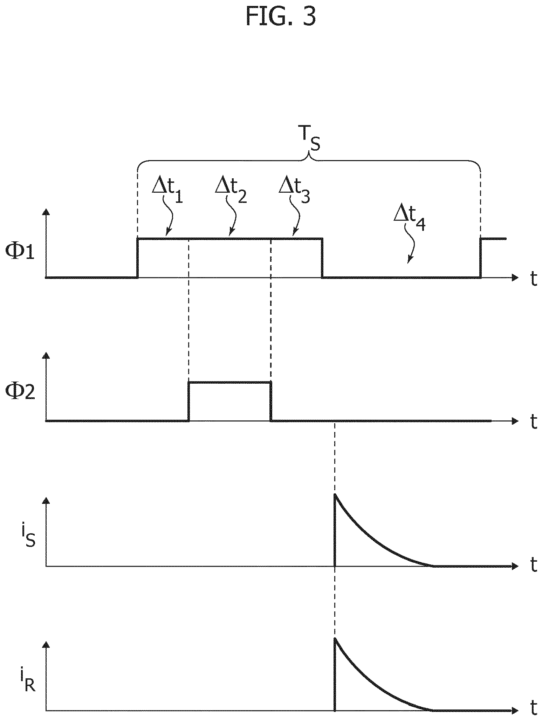

For example, as shown in Figure 3, typically, the control circuit 36 is configured to generate the control signals $\Phi_1$ and $\Phi_2$ according to switching cycles having a duration/period $T_S$. Specifically, typically, each switching cycle $T_S$ comprises a sequence of the following four phases:

- a phase $\Delta t_1$, wherein both electronic switches $M_2$ and $M_4$ are opened, *e.g.,* by setting the signal $\Phi_1$ to high and the signal $\Phi_2$ to low;
- a phase $\Delta t_2$, wherein the electronic switch $M_2$ is opened and the electronic switch $M_4$ is closed, *e.g.,* by setting the signal $\Phi_1$ to high and the signal $\Phi_2$ to high, whereby the capacitance $C_S$ discharges trough the electronic switch $M_4$ to ground;
- a phase $\Delta t_3$, wherein both electronic switches $M_2$ and $M_4$ are opened, *e.g.,* by setting the signal $\Phi_1$ to high and the signal $\Phi_2$ to low; and
- a phase $\Delta t_4$, wherein the electronic switch $M_2$ is closed and the electronic switch $M_4$ is opened, *e.g.,* by setting the signal $\Phi_1$ to low and the signal $\Phi_2$ to low, whereby the sense capacitance $C_S$ is connected to the supply voltage VDD and is charged with a current is.

Accordingly, the phase $\Delta t_2$ is used to reset the charge of the capacitance $C_S$ and the phase $\Delta t_4$ is used to charge the capacitance $C_S$. Generally, the phases $\Delta t_1$ and $\Delta t_3$ are purely optional and are used to avoid that the electronic switches $M_2$ and $M_4$ generate a short-circuit by connecting the supply voltage VDD to ground.

Accordingly, as shown in Figure 2, the interface circuit 30 may comprise a measurement circuit 34 configured to measure the charge or discharge current is flowing through the capacitance $C_S$. For example, in the example considered, the measurement circuit 34 comprises a current sensor 340 connected between the electronic switch $M_2$ and the supply voltage VDD, thereby monitoring the charge current.

Typically, the CBCM technique uses also a second branch, which comprises a reference capacitance $C_R$. Typically, the reference capacitance $C_R$ has the same physical structure as the sense capacitance Cs, but is not exposed to the sample 104. For example, in the absence of a sample 104, the capacitance values $C_S$ and $C_R$ typically correspond, *i.e.,* $C_S = C_R$. Conversely, in the presence of a sample 104, the capacitance value of the sense capacitance $C_S$ varies and usually increases, *i.e.,* $C_S > C_R$.

Accordingly, in this case, the second branch comprises:

- a first electronic switch $M_3$, such as an n-channel FET, such as a n-channel MOSFET, configured to selectively short-circuit the reference capacitance $C_R$, and
- a second electronic switch $M_1$, such as a p-channel FET, such as a p-channel MOSFET, configured to selectively connect the reference capacitance $C_R$ to the supply voltage VDD.

Typically, the electronic switch $M_3$ is driven via the control signal $\Phi_2$ and the electronic switch $M_1$ is driven via the control signal $\Phi_1$. In fact, as shown in Figure 3, in this case the reference capacitance $C_R$ is reset during the phase $\Delta t_2$ and is charged during the phase $\Delta t_4$, thereby generating a current flow $i_R$. Accordingly, also in this case the interface circuit 30 may comprise a current sensor 342 configured to measure the charge or discharge current $i_R$ flowing through the capacitance $C_R$. For example, in the embodiment considered, the current sensor 342 is connected between the electronic switch $M_1$ and the supply voltage VDD, thereby monitoring the charge current.

Accordingly, in the example considered, the interface circuit 30 comprises a first half-bridge implemented with the electronic switches $M_2$ and $M_4$, wherein the first half-bridge is configured to selectively apply a first reference voltage (usually the supply voltage VDD) or a second reference voltage (usually ground GND) to a first terminal/electrode 100 of the sense capacitance Cs, wherein the second terminal/electrode 102 of the sense capacitance $C_S$ is connected to the second reference voltage (usually ground GND). Moreover, the interface circuit 30 comprises a second half-bridge implemented with the electronic switches $M_1$ and $M_3$, wherein the second half-bridge is configured to selectively apply the first reference voltage (usually the supply voltage VDD) or the second reference voltage (usually ground GND) to a first terminal/electrode of the reference capacitance $C_R$ wherein the second terminal/electrode of the reference capacitance $C_R$ is connected to the second reference voltage (usually ground GND). The two half-bridges are identified as CBCM cell 32.

For example, when using the CMOS technology, the electronic switches $M_3$ and $M_4$ are usually implemented with n-channel MOSFETs and the electronic switches $M_1$ and $M_2$ are usually implemented with p-channel MOSFETs. In this case, the source terminals of the n-channel FETs $M_3$ and $M_4$ are connected to the second reference voltage (e.g., ground GND), the source terminals of the p-channel FETs $M_1$ and $M_2$ are connected to the first reference voltage (*e.g.,* VDD), the drain terminals of the n-channel FET $M_4$ and the p-channel FET $M_2$ are connected to the first terminal/electrode of the sense capacitance Cs, and the drain terminals of the n-channel FET $M_3$ and the p-channel FET $M_1$ are connected to the first terminal/electrode of the reference capacitance $C_R$.

Accordingly, in the CBMS technique, the properties of the sample 104 are usually evaluated based on the capacitive difference $\Delta C$ between the capacitances $C_S$ and $C_R$, *i.e.,* $\Delta C = C_S - C_R$. For example, for this purpose, the measurement circuit 32 should be configured to generate a signal indicative of the difference $\Delta i$ between the (charge or discharge) currents is and $i_R$, *i.e.,* $\Delta i = is - i_R$.

In this respect, the previously cited document by James C. Chen affirms that this technique has an intrinsic estimated sensitivity of about 10aF. Accordingly, a major technical problem resides in the design and implementation of the measurement/readout circuit of the CBCM cell 32 that does not degrade or has only a minor impact on this performance.

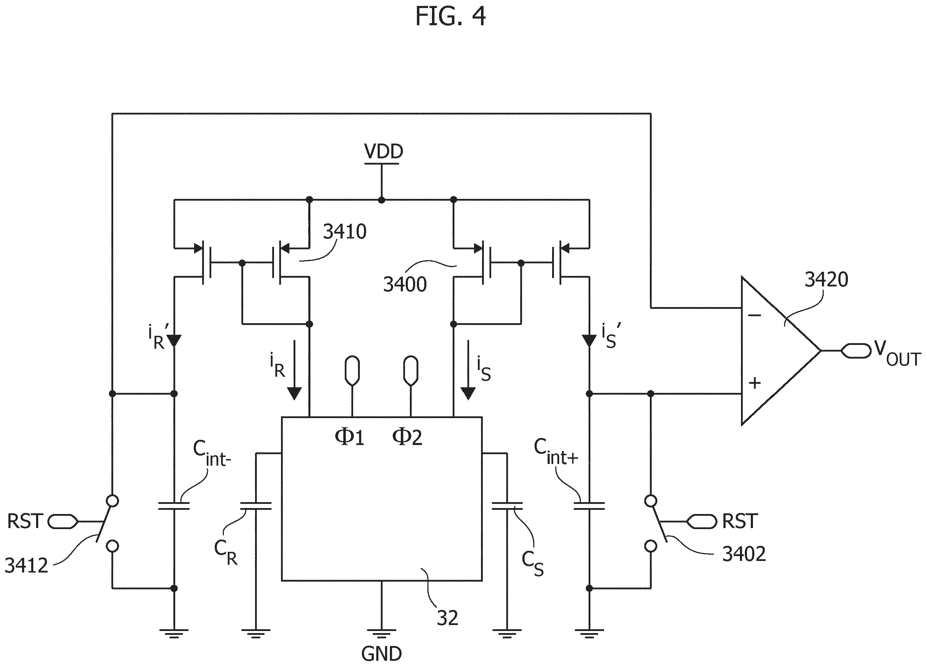

Figure 4 shows a first example of a measurement circuit of the CBCM cell 32 configured to generate a signal indicative of the difference $\Delta i$ between the currents is and $i_R$. For example, such a solution is disclosed in Saghi Forouhi, Rasoul Dehghani, and Ebrahim Ghafar-Zadeh, "Toward High Throughput Core-CBCM CMOS Capacitive Sensors for Life Science Applications: A Novel Current Mode for High Dynamic Range Circuitry", Sensors 2018.

Specifically, in the example considered, the measurement circuit of the CBCM cell 32 comprises a first current mirror 3400, *e.g.,* implemented with two p-channel FETs, configured to generate a current is' by mirroring the (charge) current is provided to the CBCM cell 32. This mirrored current is' is used to charge a first capacitance $C_{int+}$, which essentially operates as an integrator configured to convert the current is'(t) into a voltage. Similarly, the measurement circuit of the CBCM cell 32 comprises a second current mirror 3410, *e.g.,* implemented with two p-channel FETs, configured to generate a current $i_R$' by mirroring the (charge) current $i_R$ provided to the CBCM cell 32. This mirrored current $i_R$' is used to charge a second capacitance $C_{int-}$, which essentially operates as an integrator configured to convert the current $i_R$'(t) into a voltage.

Accordingly, in the example considered, a differential amplifier 3420 may be used to generate a signal, *e.g.,* a voltage $V_{out}$, by amplifying the difference between the voltage at the capacitance $C_{int+}$ and the voltage at the capacitance $C_{int-}$. For example, in the example considered, the voltage at the capacitance $C_{int+}$ is connected to the positive input terminal of the differential amplifier 3420 and the voltage at the capacitance $C_{int-}$ is connected to the negative input terminal of the differential amplifier 3420. The capacitances $C_{int+}$ and $C_{int-}$ have the same capacitance value.

In this case, usually the measurement circuit 34 also comprises electronic switches 3402 and 3412 in order to selectively discharge the capacitances $C_{int+}$ and $C_{int-}$, *e.g.,* as a function of a reset signal RST. In fact, the circuit of Figure 4 permits to execute a plurality of the switching cycles $T_S$ shown in Figure 3, whereby each time the current pulse in the currents is and $i_R$ are transferred to the capacitances $C_{int+}$ and $C_{int-}$, respectively.

Accordingly, in the example considered, the capacitances $C_S$ and $C_R$ are not charged directly with voltage VDD, but rather with a voltage (VDD - $V_{thp}$), where $V_{thp}$ corresponds to the threshold of the input FETs of the current mirrors 3400 and 3410, *i.e.,* the voltage $\Delta V$ at the input of the differential amplifier 3420 may be approximated with the following equation after a given number N of switching cycles:

$$\Delta V = N \frac{\Delta C}{C_{int}} (VDD - V_{thp}) \tag{1}$$

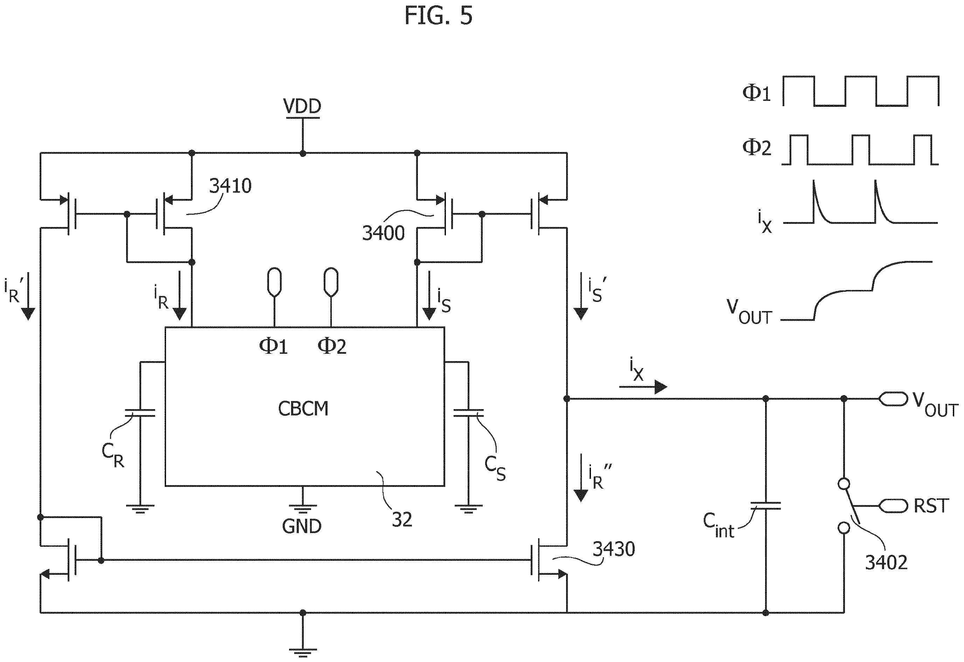

Accordingly, a first drawback relates to the fact the output $V_{out}$ is also a function of the threshold $V_{thp}$, which depends on temperature and process spread variations. Moreover, in this approach, to achieve a higher sensitivity, high voltages across the integrating capacitors $C_{int+}$ and $C_{int-}$ are required. However, this situation may push the differential amplifier 3420 to a nonlinear region, and thus limits the resolution of the sensor circuit. To mitigate this second problem, the previously cited article by Saghi Forouhi also discloses an alternative approach, which is shown in Figure 5.

Specifically, in the example shown in Figure 5, the current mirrors 3400 and 3410 are again configured to generate mirrored currents is' and $i_R$', respectively.

However, in this case a further current mirror 3430, *e.g.,* implemented with n-channel FETs, is used to generate a further mirrored current $i_R$" by mirroring the current iR'. Specifically, in the example considered, the output of the current mirror 3400 is connected in series with a capacitance $C_{int}$. Conversely, the output of the current mirror 3430 is connected in parallel with the capacitance $C_{int}$. Accordingly, in the example considered, the capacitance $C_{int}$ is indeed charged with a current ix corresponding to the difference between the currents is' and $i_R$", *i.e.,* ix = is' - $i_R$".

Accordingly, also the circuit of Figure 5 permits to execute a plurality of the switching cycles shown in Figure 3, whereby each time the current pulse in the current ix is transferred to the capacitances $C_{int}$. Specifically, by using a current mirror 3430 with a mirroring ratio of one, and current mirrors 3400 and 3410 with a mirroring ratio of K, the voltage $V_{out}$ at the capacitance $C_{int}$ may be approximated with the following equation after a given number N of switching cycles:

$$V_{out} = NK \frac{\Delta C}{C_{int}} (VDD - V_{thp}) \tag{2}$$

Generally, the previously cited document also discloses a respective differential version of the circuit shown in Figure 5.

Unfortunately, the approach shown in Figure 5 is based on several current mirrors having current gains, whose offsets and mismatches severely impact the sensing of the capacitance difference $\Delta C$. Conversely, this was only a minor problem in the solution shown in Figure 4, because current mirrors without any gain may be used.

Summary

Considering the foregoing, it is therefore an object of various embodiments to provide a measurement system, which overcomes the problems outlined in the foregoing.

According to one or more embodiments, the above object is achieved by a measurement system having the distinctive elements set forth specifically in the ensuing claims. Embodiments moreover concern a related integrated circuit and method.

The claims form an integral part of the technical teaching of the description provided herein.

As mentioned before, various embodiments of the present disclosure relate to a measurement system. In various embodiments, the measurement system comprises a first capacitance and a second capacitance. The measurement system comprises moreover a switching circuit configured to receive a first and a second control signal. In response to determining that the first control signal is asserted, the switching circuit connects a first terminal of the first capacitance to a first voltage and a first terminal of the second capacitance to a second voltage. Moreover, in response to determining that the second control signal is asserted, the switching circuit connects the first terminal of the first capacitance and the first terminal of the second capacitance to a reference voltage, *e.g.,* ground.

In various embodiments, a control circuit is configured to generate the first and the second control signal according to switching cycles comprising four intervals. Specifically, for a first interval, the control circuit de-asserts the first and the second control signal. For a following second interval, the control circuit de-asserts the first control signal and asserts the second control signal, thereby connecting the first capacitance to the first voltage and the second capacitance to the second voltage. For a following third interval, the control circuit de-asserts the first and the second control signal. Finally, for a following fourth interval, the control circuit asserts the first control signal and de-asserts the second control signal, thereby connecting the first capacitance and the second capacitance to the reference voltage.

In various embodiments, the measurement system comprises further a measurement circuit, which in turn comprises a differential integrator and a comparator with hysteresis.

In various embodiments, the differential integrator comprises a differential operational amplifier, a first integration capacitance and a second integration capacitance. Specifically, in various embodiments, an inverting input of the differential operational amplifier is connected to a second terminal of the first capacitance and a non-inverting input of the differential operational amplifier is connected to a second terminal of the second capacitance. A first terminal of the first integration capacitance is connected to the inverting input of the differential operational amplifier and a second terminal of the first integration capacitance is connected via a first electronic switch to a positive output terminal of the differential operational amplifier, wherein the second terminal of the first integration capacitance represents a first output node of the differential integrator. Similarly, a first terminal of the second integration capacitance is connected to the non-inverting input of the differential operational amplifier and a second terminal of the second integration capacitance is connected via a second electronic switch to a negative output terminal of the differential operational amplifier, wherein the second terminal of the second integration capacitance represents a second output node of the differential integrator. In various embodiments, the differential integrator comprises moreover a third electronic switch connected between the inverting input of the differential operational amplifier and the positive output terminal of the operational amplifier, and a fourth electronic switch connected between the non-inverting input of the differential operational amplifier and the negative output terminal of the operational amplifier.

In various embodiments, the comparator with hysteresis is configured to, in response to determining that a voltage applied to a negative input terminal of the comparator with hysteresis exceeds a voltage applied to a positive input terminal of the comparator with hysteresis plus a hysteresis threshold, set a first output terminal of the comparator with hysteresis to high and a second output terminal of the comparator with hysteresis to low. Moreover, in various embodiments the comparator with hysteresis comprises a fifth electronic switch connected between the negative input of the comparator with hysteresis and the second output terminal of the comparator with hysteresis, and a sixth electronic switch connected between the positive input of the comparator with hysteresis and the first output terminal of the comparator with hysteresis.

In various embodiments, a first decoupling capacitance is connected between the negative input of the comparator with hysteresis and the first output node of the differential integrator, and a second decoupling capacitance connected between the positive input of the comparator with hysteresis and the second output node of the differential integrator.

In various embodiments, the measurement system is configured to manage a normal operation phase and a reset phase.

Specifically, during the normal operation phase, the measurement system is configured to close the first electronic switch and the second electronic switch, in response to determining that the second control signal is asserted. Conversely, the measurement system is configured to open the first electronic switch and the second electronic switch

in response to determining that the second control signal is de-asserted. Moreover, the measurement system is configured to close the third electronic switch and the fourth electronic switch in response to determining that the first control signal is asserted, and open the third electronic switch and the fourth electronic switch in response to determining that the first control signal is de-asserted. Thus, when the first control signal is de-asserted and the second control signal is asserted, the first integration capacitance and the second integration capacitance are connected into the feedback paths of the differential operational amplifier, thereby permitting a charge transfer from the first and second capacitances to the first and second integration capacitances. For example, the first and the second capacitances have a different charge when the first voltage and the second voltage correspond to a common voltage, but the first capacitance corresponds to a sense capacitance and the second capacitance corresponds to a reference capacitance. In fact, in this case, the voltage between the first and second output nodes of the differential integrator is indicative of the difference between the capacitances of the sense capacitance and the reference capacitance. Conversely, when the first capacitance and the second capacitance have the same capacitance value, the voltage between the first and second output nodes of the differential integrator is indicative of the difference between the first voltage and the second voltage. During the normal operation phase, the comparator with hysteresis is thus operative, *i.e.*, the fifth electronic switch and the sixth electronic switch are opened.

In various embodiments, the measurement system monitors also a reset request signal during the normal operation phase and, in response to determining that the reset request signal indicates a reset request, the measurement system starts the reset phase. For example, in various embodiments, the measurement system is configured to assert the reset request signal after a given maximum number of the switching cycles, and/or in response to determining that the first output terminal of the comparator with hysteresis is set to high and/or the second output terminal of the comparator with hysteresis is set to low.

In various embodiments, during the reset phase, the measurement system executes one or more sub-phases. Specifically, for a first reset interval, the measurement system closes the first, second, third, fourth, fifth and sixth electronic switches. Conversely, for a following second reset interval, the measurement system may open the third and fourth electronic switches and keeps closed the first, second, fifth and sixth electronic switches. Finally, at the end of the reset phase, e.g., at the end of second phase, the measurement system starts again the normal operation phase. Specifically, as will be described in greater detail in the following, in various embodiments, apart from resetting the integration capacitances and the comparator with hysteresis, the offsets and most of the flicker noise of the differential operational amplifier and the comparator with hysteresis may be stored to the decoupling capacitance during the first reset interval. Moreover, during the second reset interval, also the charge-injection and clock-feedthrough of the third and fourth electronic switches may be stored to the decoupling capacitance.

For example, in order to implement the described reset phase, the differential integrator may receive a first reset signal, and the third electronic switch and the fourth electronic switch may be configured to be closed in response to determining that the first control signal is asserted or the first reset signal is asserted. Moreover, the comparator with hysteresis may be configured to receive a second reset signal, wherein the fifth electronic switch and the sixth electronic switch are configured to be closed in response to determining that the second reset signal is asserted. Accordingly, in this case, the measurement system may be configured to, while the control circuit asserts the second control signal, assert the first reset signal and the second reset signal for the first reset interval, and de-assert the first reset signal and assert the second reset signal for the second reset interval. For example, for this purpose the measurement system may comprise a delay circuit configured to generate the second reset signal by delaying the first reset signal.

Accordingly, various embodiments relate to a corresponding method of operating such a measurement system. Specifically, during a normal operation phase, the method closes the first electronic switch and the second electronic switch in response to determining that the second control signal is asserted, and opens the first electronic switch and the second electronic switch in response to determining that the second control signal is de-asserted. Moreover, the method closes the third electronic switch and the fourth electronic switch in response to determining that the first control signal is asserted, and opens the third electronic switch and the fourth electronic switch in response to determining that the first control signal is de-asserted. In various embodiments, when using the fifth electronic switch and the sixth electronic switch, the method may also open the fifth electronic switch and the sixth electronic switch during a normal operation phase.

In various embodiments, the method may monitor a reset request signal indicating a reset request and start a reset phase in response to determining that the reset request signal indicates a reset request. Specifically, during the reset phase, the method closes the first, second, third, fourth electronic switches for a first reset interval. Moreover, when using the fifth and sixth electronic switches, the method may close the fifth and sixth electronic switches. Preferably, in this case, the measurement system comprises the decoupling capacitances. Next, the method starts again the normal operation phase.

In various embodiments, when using the decoupling capacitances, the method may also open the third and fourth electronic switches and keep closed the first, second, fifth and sixth electronic switches for a following second reset interval following the first reset interval (and before the normal operation mode is started again).

Brief description of the annexed drawings

The embodiments of the present disclosure will now be described with reference to the annexed plates of drawings, which are provided purely to way of non-limiting example and in which:
The features and advantages of the present invention will become apparent from the following detailed description of practical embodiments thereof, shown by way of non-limiting example in the accompanying drawings, in which:

- Figure 1 shows an example of a capacitive sensor;
- Figures 2 shows an example of a measurement system for capacitive sensors;
- Figure 3 shows waveforms of the measurement system of Figure 2;
- Figures 4 and 5 show possible implementations of the measurement system of Figure 2;
- Figure 6 shows an embodiment of a measurement system according to the present disclosure;
- Figure 7 shows an embodiment of a measurement circuit of the measurement system of Figure 6;
- Figures 8A, 8B and 8C show embodiments of switching circuits of the measurement system of Figure 6;
- Figure 9 shows an embodiment of waveforms of the measurement system of Figure 6;
- Figure 10 shows a detail of the measurement circuit of Figure 7; and
- Figures 11, 12, 13 and 14 show further embodiments of switching circuits of the measurement system of Figure 6.

Detailed description of embodiments

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not shown or described in detail so that various aspects of the embodiments will not be obscured.

Reference to "an embodiment" or "one embodiment" in the framework of this description is meant to indicate that a particular configuration, structure, or characteristic described in relation to the embodiment is comprised in at least one embodiment. Hence, phrases such as "in an embodiment", "in one embodiment", or the like that may be present in various points of this description do not necessarily refer to one and the same embodiment. Moreover, particular conformations, structures, or characteristics may be combined in any adequate way in one or more embodiments.

The references used herein are only provided for convenience and hence do not define the sphere of protection or the scope of the embodiments.

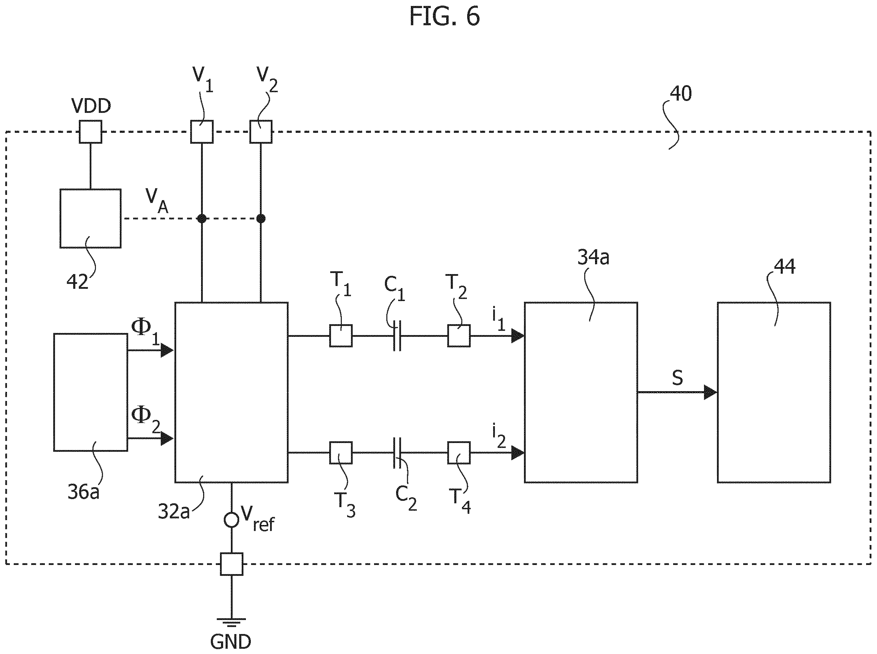

In Figures 6 to 14 described below, parts, elements or components that have already been described with reference to Figures 1 to 5 are designated by the same references used previously in these figures. The description of these elements has already been made and will not be repeated in what follows in order not to burden the present detailed description.

As mentioned before, various embodiments of the present disclosure relate to a measurement system.

Figure 6 shows an embodiment of a measurement system according to the present disclosure. For example, such a measurement system may be integrated in an integrated circuit 40. In the embodiment considered, the measurement system comprises a switching circuit 32a comprising three terminals:

- a first terminal configured to be connected to a reference voltage $V_{ref}$, such as ground GND;
- a second terminal configured to be connected to a first voltage $V_1$, wherein the first voltage is greater than the reference voltage $V_{ref}$/ground GND; and
- a third terminal configured to be connected to a second voltage $V_2$, wherein the second voltage is greater than the reference voltage $V_{ref}$/ground GND.

As will be described in greater detail in the following, in various embodiments, the voltages $V_1$ and $V_2$ may also correspond to the same voltage, indicated in the following as voltage $V_A$. For example, in various embodiments, the measurement system may comprise a voltage generator 42 configured to receive a supply voltage VDD, e.g., via a pad/pin of the integrated circuit 40, and generate the voltage $V_A$ based on this supply voltage VDD.

In the embodiment considered, the measurement system has associated two capacitances $C_1$ and $C_2$. These capacitances are preferably integrated in the measurement system for best matching. In general, the capacitance has two terminals $T_1$ and $T_2$, and the capacitance has two terminals $T_3$ and $T_4$.

Specifically, in various embodiments, the switching circuit 32a receives a first control signal $\Phi_1$ and a secondo control signal $\Phi_2$. For example, the control signal $\Phi_1$ and $\Phi_2$ may be generated by a control circuit 36a of the measurement system. Specifically, similar to the previous description, the control circuit 36a may be configured to generate the control signals $\Phi_1$ and $\Phi_2$ according to switching cycles having a duration/period Ts, wherein each switching cycle $T_S$ comprises a sequence of the following four phases:

- a phase $\Delta t_1$, wherein the signals $\Phi_1$ and $\Phi_2$ are de-asserted;
- a phase $\Delta t_2$, wherein the signal $\Phi_1$ is de-asserted and the signal $\Phi_2$ is asserted;
- a phase $\Delta t_3$, wherein the signals $\Phi_1$ and $\Phi_2$ are de-asserted;
- a phase $\Delta t_4$, wherein the signal $\Phi_1$ is asserted and the signal $\Phi_2$ is de-asserted;

For example, in various embodiments, the switching circuit 32a is configured to:

- in response to determining that the signal $\Phi_1$ is asserted and the signal $\Phi_2$ is de-asserted, connect the terminal $T_1$ to the voltage $V_1$ and the terminal $T_3$ to the voltage $V_2$;
- in response to determining that the signal $\Phi_1$ is de-asserted and the signal $\Phi_2$ is asserted, connect the terminals $T_1$ and $T_3$ to the reference voltage $V_{ref}$/ground GND; and
- in response to determining that the signals $\Phi_1$ and $\Phi_2$ are de-asserted, put the terminals $T_1$ and $T_3$ in a high-impedance state, *e.g.*, by disconnecting the terminals $T_1$ and $T_3$.

Accordingly, in various embodiments, the switching circuit 32a is configured to apply the reference voltage $V_{ref}$, or the voltages $V_1$ and $V_2$, to the terminals $T_1$ and $T_3$ of the capacitances $C_1$ and $C_2$, respectively.

Accordingly, in various embodiments, a measurement circuit 34a is configured to monitor a current $i_1$ flowing through the capacitance $C_1$ and a current $i_2$ flowing through the capacitance $C_2$.

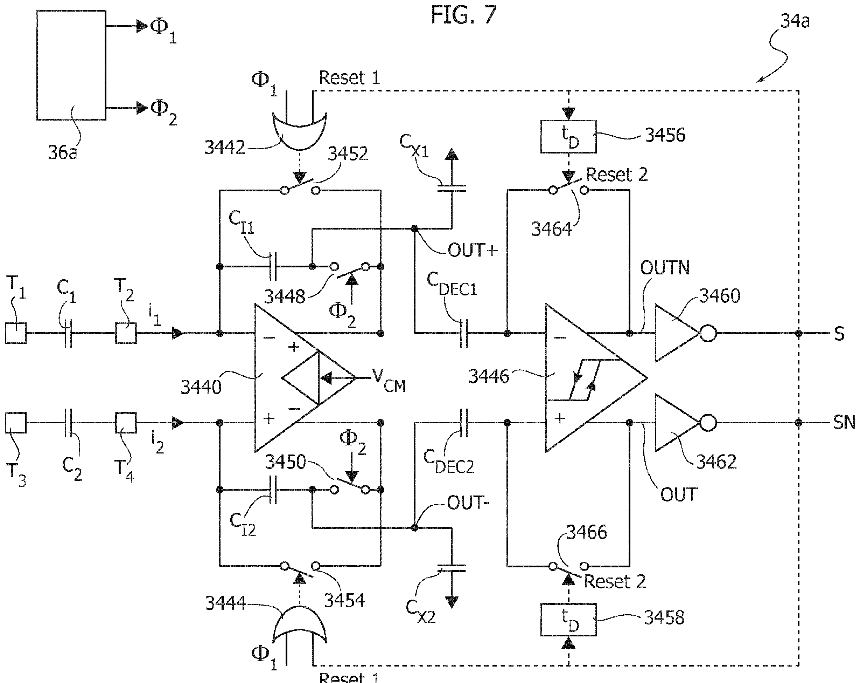

Figure 7 shows an embodiment of a measurement circuit 34a according to the present disclosure.

Specifically, in the embodiment considered, the measurement circuit 34a is implemented with a switched capacitor (SC) differential integrator. Specifically, in the embodiment considered, the differential integrator comprises a differential operational amplifier 3440, wherein the inverting/negative input terminal of the operational amplifier 3440 is connected (*e.g.*, directly) to the terminal $T_2$ of the capacitance $C_1$, and the non-inverting/positive input terminal of the operational amplifier 3440 is connected (*e.g.*, directly) to the terminal $T_4$ of the capacitance $C_2$. Specifically, in order to implement a differential integrator configured to integrate the difference $\Delta i$ between the currents $i_1$ and $i_2$ during the discharge phase, *i.e.*, when the signal $\Phi_2$ is asserted, the differential integrator comprises:

- a first integration capacitance $C_{I1}$, wherein a first terminal of the integration capacitance $C_{I1}$ is connected (*e.g.*, directly) to the inverting/negative input terminal of the operational amplifier 3440 and a second terminal of the first integration capacitance $C_{I1}$ is connected (*e.g.*, directly) via the current path of an electronic switch 3448 to the positive output terminal of the operational amplifier 3440;
- a second integration capacitance $C_{I2}$, wherein a first terminal of the integration capacitance $C_{I2}$ is connected (*e.g.*, directly) to the non-inverting/positive input terminal of the operational amplifier 3440 and a second terminal of the second integration capacitance $C_{I2}$ is connected (*e.g.*, directly) via the current path of an electronic switch 3450 to the negative output terminal of the operational amplifier 3440.

Specifically, the electronic switches 3448 and 3450 are driven by the signal $\Phi_2$, and are closed when the signal $\Phi_2$ is asserted. Accordingly, in the embodiment considered, the electronic switches 3448 and 3450 are closed when the signal $\Phi_2$ is asserted, *i.e.*, during the discharge phase, thereby connecting the integration capacitances $C_{I1}$ and $C_{I2}$ into the feedback paths of the operation amplifier 3440. In various embodiments, the first and second integration capacitance $C_{I1}$ and $C_{I2}$ have the same capacitance $C_I$. For example, the capacitances $C_{I1}$ and $C_{I2}$ may be implemented with internal capacitors for best matching with the capacitances $C_1$ and $C_2$.

Moreover, in the embodiment considered, the current path of an electronic switch 3452 is connected (*e.g.*, directly) between the inverting/negative input terminal of the operational amplifier 3440 and the positive output terminal of the operational amplifier 3440, and the current path of an electronic switch 3454 is connected (*e.g.*, directly) between the non-inverting/positive input terminal of the operational amplifier 3440 and the negative output terminal of the operational amplifier 3440. Specifically, the electronic switches 3452 and 3454 are driven by the signal $\Phi_1$, and are closed when the signal $\Phi_1$ is asserted. Accordingly, the electronic switches 3452 and 3454 are closed when the signal $\Phi_1$ is asserted, *i.e.*, during the charge phase, thereby short-circuiting the feedback paths of the operation amplifier 3440.

As schematically shown in Figure 7, the differential operational amplifier 3440 has also associated a respective common mode voltage $V_{CM}$, which may be fixed or settable.

Accordingly, when the signal $\Phi_1$ is asserted, the input terminals of the operational amplifier 3440 are set to the common mode voltage $V_{CM}$, which permits to charge the capacitances $C_1$ and $C_2$ via the voltages $V_1$ and $V_2$. Conversely, when the signal $\Phi_2$ is asserted, the integration capacitances $C_{I1}$ and $C_{I2}$ are connected to the operational amplifier 3440 and the previously charged capacitances $C_1$ and $C_2$ discharge to the reference voltage $V_{ref}$/ground GND. Specifically, the charge applied to the capacitances $C_1$ and $C_2$ is different, *e.g.*, when:

- the voltages $V_1$ and $V_2$ have the same value, *e.g.*, $V_A$, but the capacitances $C_1$ and $C_2$ are different, which thus permits to monitor the difference between the capacitances $C_1$ and $C_2$, or

- the capacitances $C_1$ and $C_2$ have the same value, but the voltages $V_1$ and $V_2$ are different, which thus permits to monitor the difference between the voltages $V_1$ and $V_2$.

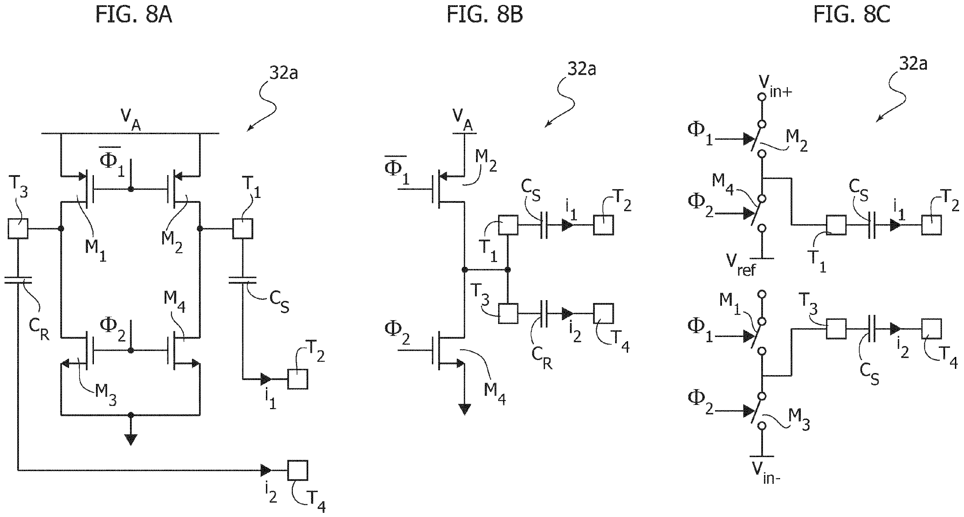

For example, Figures 8A, 8B and 8C show possible embodiments of the switching circuit 32a and the capacitances $C_1$ and $C_2$.

Specifically, in Figures 8A and 8B, the capacitance $C_1$ corresponds to a sense capacitance $C_S$ and the capacitance $C_2$ corresponds to a reference capacitance $C_R$, *i.e.,* the capacitance $C_S$ has a variable capacitance value. Moreover, in this case, the voltages $V_1$ and $V_2$ are connected to a common voltage $V_A$, which may be provided via a terminal/pad/pin of the measurement system or via the voltage generator 42.

For example, the switching circuit 32a of Figure 8A essentially corresponds to the switching circuit 32 shown in Figure 2. Specifically, in the embodiment considered, the current path of a first electronic switch $M_4$, such as a transistor, such as an n-channel FET, such as an n-channel MOSFET, is connected (*e.g.,* directly) between the terminal $T_1$ and the reference voltage $V_{ref}$/ground GND. Moreover, the current path of a second electronic switch $M_2$, such as a transistor, such as an p-channel Field-effect transistor (FET), such as an p-channel MOSFET, is connected (*e.g.,* directly) between the terminal $T_1$ and the voltage $V_A$. Similarly, the current path of a third electronic switch $M_3$, such as a transistor, such as an n-channel FET, such as an n-channel MOSFET, is connected (*e.g.,* directly) between the terminal $T_3$ and the reference voltage $V_{ref}$/ground GND. Moreover, the current path of a fourth electronic switch $M_1$, such as a transistor, such as an p-channel Field-effect transistor (FET), such as an p-channel MOSFET, is connected (*e.g.,* directly) between the terminal $T_3$ and the voltage $V_A$.

For example, when the electronic switches $M_1$ and $M_2$ are implemented with p-channel FETs, the switches $M_1$ and $M_2$ are indeed closed when the signal $\Phi_1$ is set to low. Thus, when the control circuit 36a is configured to assert the signal $\Phi_1$ by setting signal $\Phi_1$ to high, indeed the inverted signal $\overline{\Phi}_1$ may be used to drive the gate terminal of the p-channel FETs $M_1$ and $M_2$ (see also Figure 8A).

Accordingly, in the embodiment shown in Figure 8A, the two half-bridges formed by the switches $M_1/M_3$ and $M_2/M_4$ indeed operate in parallel based on the same control signals. Accordingly, as shown in Figure 8B, in various embodiments, the electronic switches $M_1$ and $M_3$ may be omitted, and the terminal $T_3$ of the reference capacitance $C_R$ may be connected (*e.g.,* directly) to the terminal $T_1$ of the sense capacitance $C_S$.

Conversely, in Figure 8C, the capacitances $C_1$ and $C_2$ have the same value $C_S$. Moreover, the voltages $V_1$ is connected to a voltage $V_{in+}$ and the voltages $V_2$ is connected to a voltage $V_{in-}$.

Accordingly, also in this case may be used two half-bridges. For example, in the embodiment considered, the current path of a first electronic switch $M_4$, such as a transistor, such as an n-channel FET, such as an n-channel MOSFET, is connected (*e.g.,* directly) between the terminal $T_1$ and the reference voltage $V_{ref}$/ground GND. Moreover, the current path of a second electronic switch $M_2$, such as a transistor, such as an p-channel Field-effect transistor (FET), such as an p-channel MOSFET, is connected (*e.g.,* directly) between the terminal $T_1$ and the voltage $V_{in+}$. Similarly, the current path of a third electronic switch $M_3$, such as a transistor, such as an n-channel FET, such as an n-channel MOSFET, is connected (*e.g.,* directly) between the terminal $T_3$ and the reference voltage $V_{ref}$/ground GND. Moreover, the current path of a fourth electronic switch $M_1$, such as a transistor, such as an p-channel Field-effect transistor (FET), such as an p-channel MOSFET, is connected (*e.g.,* directly) between the terminal $T_3$ and the voltage $V_{in-}$.

Accordingly, the embodiments shown in Figures 8A and 8B may be used to monitor the difference $\Delta C$ between the capacitances $C_S$ and $C_R$, while the embodiment shown in Figure 8C may be used to monitor the amplitude of a differential voltage $\Delta V_{in}$ corresponding to the difference between the voltages $V_{in+}$ and $V_{in-}$.

For example, when using the measurement circuit 34a of Figure 7 with the switching circuits 32a shown in Figures 8A and 8B, the following net charge will be injected into the integration capacitances $C_{I1}$ and $C_{I2}$ at each switching cycle Ts:

$$\Delta Q = (C_S - C_R)V_A = \Delta C \, V_A \qquad (3)$$

Accordingly, assuming that the capacitances $C_{I1}$ and $C_{I2}$ have the same value $C_I$ and when repeating a given number N of switching cycles Ts, the differential output voltage $V_{O,AMP}$ of the operational amplifier 3440 during the intervals when the signal $\Phi_2$ is asserted is given by:

$$V_{O,AMP} = N\frac{\Delta C}{C_I}V_A \qquad (4)$$

Conversely, when using the measurement circuit 34a of Figure 7 with the switching circuits 32a shown in Figure 8C, the capacitances $C_S$ are reset to the common mode voltage $V_{CM}$ when the signal $\Phi_1$ is asserted. Conversely, when the signal $\Phi_2$ is asserted, a differential voltage $\Delta V_{in}$ (between $V_{in+}$ and $V_{in-}$) is applied to the capacitors Cs, thereby injecting the following net charge at each switching cycle Ts:

$$\Delta Q = (V_{in+} - V_{in-})C_S = \Delta V_{in}\, C_S \tag{5}$$

Accordingly, assuming that the capacitances $C_{I1}$ and $C_{I2}$ have the same value $C_I$ and when repeating a given number N of switching cycles Ts, the differential output voltage $V_{O,AMP}$ of the operational amplifier 3440 during the intervals when the signal $\Phi_2$ is asserted is given by:

$$V_{O,AMP} = N\frac{C_S}{C_I}\Delta V_{in} \tag{5}$$

Specifically, when opening the electronic switches 3448 and 3450 once the signal $\Phi_2$ is de-asserted, the differential voltage $V_{O,AMP}$ is maintained stored at the intermediate nodes between the integration capacitances ($C_{I1}$ or $C_{I2}$) and the electronic switch (3448 or 3450). Accordingly, in the embodiment considered, the second terminal of the integration capacitance $C_{I1}$, *i.e.,* the intermediate node between the capacitance Cn and the electronic switch 3448, represents a first output terminal OUT+ of the integrator circuit, and the second terminal of the integration capacitance $C_{I2}$, *i.e.,* the intermediate node between the capacitance $C_{I2}$ and the electronic switch 3450, represents a second output terminal OUT-of the integrator circuit, wherein the output terminals OUT+ and OUT- provide a differential voltage $V_O$, *e.g.,* corresponding to the previously indicated voltages $V_{O,AMP}$.

In various embodiments, the measurement circuit 34a may be configured to assert a signal S when the voltage $V_O$ exceeds a reference threshold within a given monitoring interval, which comprises a given number N of switching/integration cycles Ts, thereby indicating that current difference $\Delta i = i_1 - i_2$ exceeds a given threshold value, which in turn may indicate that the capacitance difference $\Delta C$ (*e.g.,* Figures 8A or 8B) or the differential voltage $\Delta V_{in}$ (*e.g.,* Figure 8C) exceeds a respective threshold. For example, the signal S may be provided to a terminal/pad/pin of the measurement system or, as shown in Figure 6, to a digital and/or analog processing circuit 44 of the measurement system. For example, the processing circuit 44 may be a microprocessor programmed via software instructions.

Specifically, in various embodiments, the signal S is generated via a differential comparator with hysteresis 3446 configured to assert the signal S when the voltage $V_O$ exceeds the hysteresis threshold of the comparator 3446.

In general, such a comparator with hysteresis 3446 comprises two input terminals for receiving a differential voltage $\Delta V_{CMP}$ and two output terminals form providing signals OUT and OUTN, wherein the comparator 3446 is configured to set the signal OUT to high and the signal OUTN to low in response to determining that the voltage at the negative input terminal exceeds the voltage at the positive input terminal plus a first hysteresis voltage $V_{H1}$ of the comparator. Similarly, the comparator 3446 is configured to set the signal OUT to low and the signal OUTN to high in response to determining that the voltage at the negative input terminal falls below the voltage at the positive input terminal minus a second hysteresis voltage $V_{H2}$. In various embodiments, the first hysteresis voltage $V_{H1}$ and the second hysteresis voltage $V_{H2}$ have the same absolute value $V_H$.

Accordingly, in the embodiment considered, the signal S may correspond, *e.g.,* to the signal OUT. Conversely, in the embodiment considered, the measurement circuit 34a comprises a first inverter 3460 configured to generate the signal S by inverting the signal OUTN. In this case, the measurement circuit 34a comprises preferably also a second inverter 3462 configured to generate a signal SN by inverting the signal OUT. Specifically, these inverters 3460 and 3462 are useful in case the signals S and/or SN are used to drive other circuits, and may also be useful in order to balance the output terminals of the comparator with hysteresis 3446. In general, the inverters 3460 and 3462 may also be replaced with a more complex driver stage, *e.g.,* comprising a cascade of inverters and/or other logic gates.

In the embodiment considered, the input terminals of the comparator 3446 are not connected directly to the nodes OUT+ and OUT-, but one of the input terminals of the comparator 3446, *e.g.,* the negative input terminal, is connected (*e.g.,* directly) via a first capacitance/capacitor $C_{DEC1}$ to the node OUT+ and the other input terminal of the comparator 3446, *e.g.,* the positive input terminal, is connected (*e.g.,* directly) via a second capacitance/capacitor $C_{DEC2}$ to the node OUT-. These capacitances $C_{DEC1}$ and $C_{DEC2}$ have the same capacitance value $C_{DEC}$.

On the one hand, these capacitances $C_{DEC1}$ and $C_{DEC2}$ represent decoupling capacitances between the integrator and the comparator, which thus only transfer the variations of the voltages at the nodes OUT+ and OUT- to the input terminals of the comparator. However, in various embodiments, also the offsets and most of the flicker noise of the operational amplifier 3440 and the comparator with hysteresis 3446 may be stored to the capacitances $C_{DEC1}$ and $C_{DEC2}$ during a reset phase whereby these voltages are then cancelled during the subsequent sensing operation.

Specifically, in various embodiments, to order to start a new measurement cycle, an asynchronous reset is performed once the signal S is asserted, *i.e.,* the signal S corresponds to a reset signal Reset1.

In general, the integrator 3440 may be reset by short-circuiting the integration capacitances $C_{I1}$ and $C_{I2}$. For example, in Figure 7, the integration capacitances $C_{I1}$ and $C_{I2}$ are reset, when the electronic switches 3448, 3450, 3452 and 3454 are closed contemporaneously. For example, in the embodiments considered, the electronic switches 3452 and 3454 are closed when the signal $\Phi_1$ is asserted or the reset signal Reset1/S is asserted. For example, in the embodiment considered, the electronic switches 3452 and 3454 are driven via logic OR gates 3442 and 3444 configured to combine the signals $\Phi_1$ and Reset1.

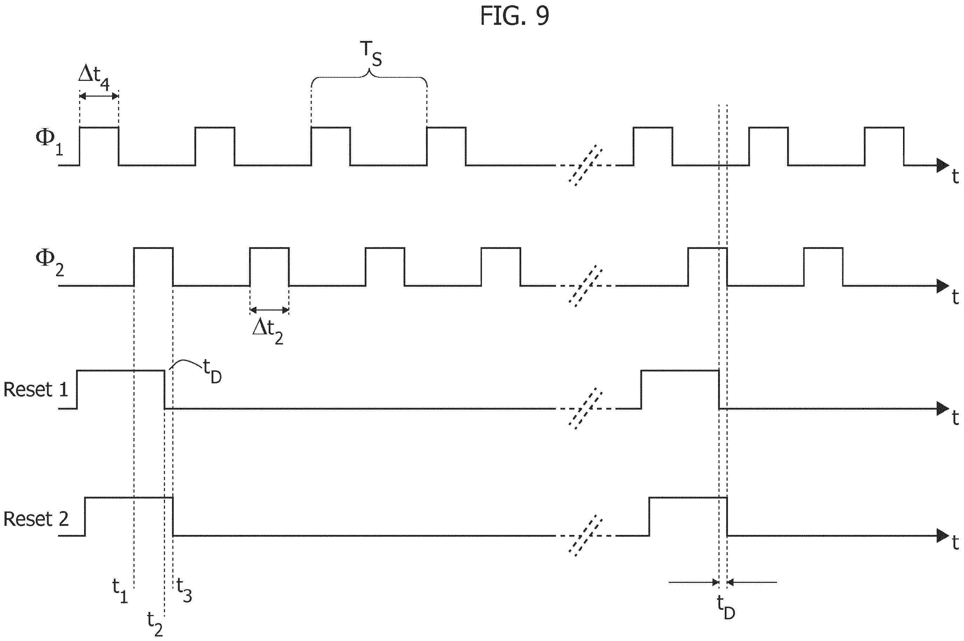

Accordingly, as shown in Figure 9, once the signal S is asserted during a given discharge phase $\Delta t_4$ (when the signal $\Phi_1$ is asserted), the reset signal Reset1 is also asserted. Accordingly, at the next charge phase $\Delta t_2$ (when the signal $\Phi_2$ is asserted), the integration capacitances $C_{I1}$ and $C_{I2}$ are short-circuited, whereby the integrator is reset.

In various embodiments, also the comparator with hysteresis 3446 is reset during the reset phase. For example, in various embodiments, the comparator 3446 is reset by closing an electronic switch 3464 configured to short-circuit the output terminal OUTN and the negative input terminal of the comparator 3446 and an electronic switch 3466 configured to short-circuit the output terminal OUT and the positive input terminal of the comparator 3446.

In various embodiments, the electronic switches 3464 and 3466 are closed when the signal Reset1 is asserted. Conversely, in the embodiment shown in Figure 7, the electronic switches 3464 and 3466 are closed when a reset signal Reset2 is asserted, wherein the reset signal Reset2 corresponds to the reset signal Reset1 with a given delay $t_D$. For example, the reset signal Reset2 may be generated via a delay circuit 3456, such as a delay line, receiving the reset signal Reset1 as input. For example, Figure 7 shows a first delay circuit 3456 configured to generate the drive signal of the electronic switch 3464 by delaying the signal Reset1, and a second delay circuit 3458 configured to generate the drive signal of the electronic switch 3466 by delaying the signal Reset1.

Accordingly, as shown in Figure 9, when the signal S/Reset1 is asserted and the control circuit 32a asserts at an instant $t_1$ the signal $\Phi_2$, the capacitances $C_{I1}$ and $C_{I2}$ are discharged and the comparator 3446 is reset. Accordingly at a following instant $t_2$ the signal S goes to low. However, this falling edge is just propagated to the reset signal Reset2 after a delay $t_D$. Accordingly, for the time $t_D$, the reset signal Reset1 is de-asserted (and similarly the signal $\Phi_1$), while the signal $\Phi_2$ and the reset signal Reset2 are still asserted. Accordingly, in this condition the electronic switches 3452 and 3454 are opened and:

- the electronic switches 3448 connect the capacitance $C_{I1}$ between the inverting/negative input terminal of the operational amplifier 3440 and the positive output terminal of the operational amplifier 3440;
- the electronic switches 3450 connect the capacitance $C_{I2}$ between the non-inverting/positive input terminal of the operational amplifier 3440 and the negative output terminal of the operational amplifier 3440;
- the electronic switch 3464 connects the negative input terminal of the comparator 3446 to the terminal OUTN; and
- the electronic switch 3466 connects the positive input terminal of the comparator 3446 to the terminal OUT.

Accordingly, in the embodiment considered, the offsets and most of the flicker noise of the operational amplifier 3440 and the comparator with hysteresis 3446 are stored to the capacitances $C_{DEC1}$ and $C_{DEC2}$ during the interval between the instants $t_1$ and $t_2$. Conversely, when using the optional delay $t_D$, also the charge-injection and clock-feedthrough of the switches 3452 and 3454 may be stored to the capacitances $C_{DEC1}$ and $C_{DEC2}$.

In this respect, the inventors have observed that the remaining error may in this way be reduced to the mismatch of the charge-injection and clock-feedthrough of the switches 3464 and 3466 driven by the reset signal Reset2, *i.e.,* $V_{error} = \Delta Q_{SW}/C_{DEC}$, wherein the voltage $V_{error}$ is usually in the micro-Volt range, and usually can be neglected or anyway absorbed by the comparator hysteresis.

In this respect, the inventors have observed that a smaller threshold voltage $V_{H1}$ permits a faster detection, *e.g.,* of the sample passing over the electrodes 100 and 102 forming the capacitance $C_S$. However, such a smaller threshold voltage $V_{H1}$ may imply thermal noise and the charge injection/clock feedthrough mismatch of the switches 3464 and 3466 driven by the signal Reset2 on the measurement.

Additionally or alternatively to the asynchronous reset triggered by the signal S, the reset of the measurement circuit 34a may also be managed based on a timeout, which is used to trigger similar reset phases of the integrator and the comparator. In fact, in line with the previous description, in various embodiments, the measurement system comprises a reset circuit configured to execute, in response to a reset request signal indicating a reset request, such as a rising edge of the signal S, a signal indicating that a given maximum number N of switching cycles have been executed, etc., the following phases in sequence:

- in an optional first phase, *e.g.,* between the rising edge of the Reset1 signal and instant $t_1$, close the electronic switches 3452, 3454, 3464 and 3466;
- in a (immediately following) second phase, e.g., between the instants $t_1$ and $t_2$, close the electronic switches 3448, 3450, and keep closed the electronic switches 3452, 3454, 3464 and 3466;
- in an optional (immediately following) third phase, *e.g.,* between the instants $t_2$ and $t_3$, open the electronic switches 3452 and 3454 and keep closed the electronic switches 3448, 3450, 3464 and 3466.

In various embodiments, in order to absorb the differential charge injection of the feedback switches 3448 and 3450 driven by $\Phi_2$ in presence of a differential signal at the output terminals of the operational amplifier 3440, these switches may be equipped with dummy switches and/or capacitor Cx is added.

For example, in the embodiment shown in Figure 7, a first capacitor $C_{X1}$ is connected (*e.g.,* directly) between the terminal OUT+ and a reference voltage, such as ground GND, and a second capacitor $C_{X2}$ is connected (*e.g.,* directly) between the terminal OUT- and the reference voltage, such as ground GND. The capacitors $C_{X1}$ and $C_{X2}$ have the same capacitance value.

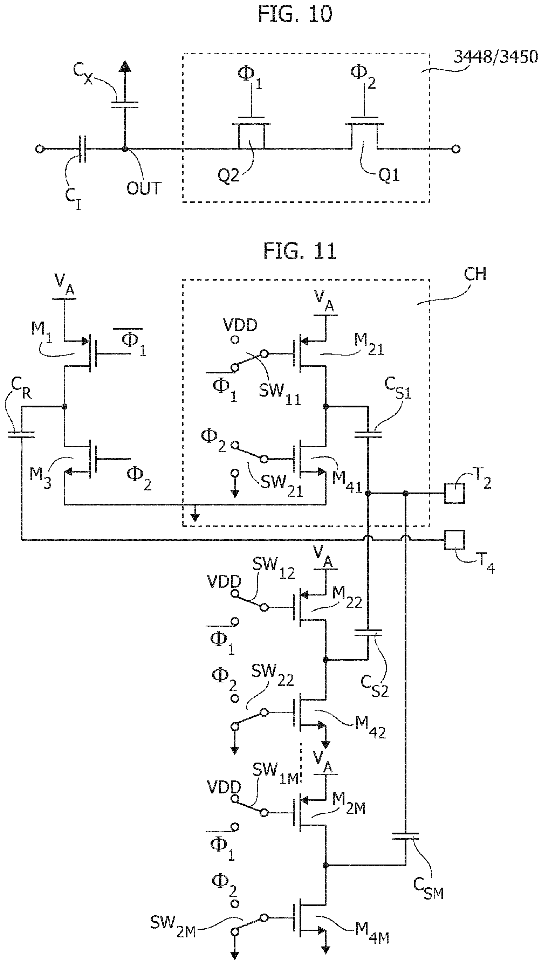

Conversely, Figure 10 shows a possible implementation of each of the switches 3448 and 3450.

Specifically, in the embodiment considered, a first terminal of a respective integration capacitance $C_{I1}$ or $C_{I2}$, indicated generically as $C_I$ in Figure 10, is connected to a respective input terminal of the operational amplifier 3440 and the electronic switch 3448/3450 is connected between the second terminal of the respective integration capacitance $C_I$ and a respective output node of the operational amplifier 3440, wherein the intermediate node between the integration capacitance $C_I$ and the electronic switch 3448/3450 corresponds to an output node OUT+ or OUT- of the integrator, generically indicated as node OUT. As mentioned before, optionally a capacitor $C_{X1}$ or $C_{X2}$, generically indicated as capacitor Cx in Figure 10, may be connected between the output node OUT and a reference voltage, *e.g.,* ground GND.

Specifically, in the embodiment considered, each electronic switch 3448/3450 is implemented with a series connection of two FETs Q1 and Q2, such as n-channel FETs. Specifically, the first FET Q1 is driven via the signal $\Phi_2$. Conversely, the second FET Q2 is a dummy switch, wherein the source and drain terminals of the FET Q2 are short-circuited. Moreover, the gate terminal of the FET Q2 is driven via a signal being asserted when the signal $\Phi_2$ is de-asserted, such as the inverted version of the signal $\Phi_2$ or preferably the signal $\Phi_1$. Preferably, the FET Q1 has a given size ratio $W_1/L_1$ (channel width/length), and the FET has a ratio $W_2/L_2$ corresponding to 0.5 $W_1/L_1$. Generally, such dummy switches Q2 for reducing the charge injection are well-known.

Accordingly the solutions described in the foregoing have the advantage that the voltage $V_{O,AMP}$ and similarly $V_O$ is not sensitive to process parameters, such as the MOS voltage threshold of the current mirrors of the prior-art solution. Moreover, the voltages $V_1$ and $V_2$ may be external or internal voltages. For example, the voltage $V_A$ may correspond to a supply voltage VDD of the integrated circuit 40 or a reference voltage provided by the voltage reference 42. Specifically, when using an internal voltage reference 42 configured to generate the voltage $V_A$, also the threshold value $V_{H1}$ (and optionally $V_{H2}$) may be proportional the voltage $V_A$, thereby permitting a tracking of variation of the voltage $V_A$ variations. Conversely, a higher sensitivity can be achieved when using the (greater) supply voltage VDD.

For example, in various embodiment, the integration capacitances $C_{I1}$ and $C_{I2}$ have a capacitance value of 0.1 pF, the period of a switching cycle $T_S$ is 1 $\mu$s, the voltage $V_A$ has a value of 2.5 V, and the comparison threshold $V_{H1}$ (and optionally $V_{H2}$) is 5 mV. For example, assuming a capacitance difference $\Delta C$ of 10 aF, the voltage $V_O$ reaches the comparison threshold $V_{H1}$ after N = 20 switching cycles $T_S$. Thus, in this example, the measurement system is able to detect the presence or absence of a sample, such as a sample with small radius crossing the plates of capacitor Cs, producing a change $\Delta C$ of 10 aF in approximately 20 $\mu$s. Conversely, assuming a capacitance difference $\Delta C$ of 40 aF, the voltage $V_O$ reaches the comparison threshold $V_{H1}$ after N = 5 switching cycles Ts, *i.e.,* the measurement system is able to detect the presence or absence of a sample producing a change $\Delta C$ of 40 aF in approximately 5 $\mu$s.

In general, the measurement circuit 34a disclosed in the foregoing may also be used with a plurality of capacitive sensors. For example, such capacitive sensors may form part of a capacitive touch sensor, such as a touch screen.

For example, Figure 11 shows an embodiment, wherein a single reference capacitance $C_R$ and a given number M of sense capacitances $C_{S1}$, $C_{S2}$, ... $C_{SM}$ are used.

Specifically, similar to Figure 8A, a first terminal of the reference capacitance $C_R$ is again connected (*e.g.,* directly) to the node $T_4$ connected to the measurement circuit 34a and the second terminal of the reference capacitance $C_R$ is again connected (*e.g.,* directly) to the intermediate node of the half-bridge formed by the electronic switches $M_1$ and $M_3$. Conversely, a first terminal of each sense capacitance $C_{S1}$, $C_{S2}$, ... $C_{SM}$ is connected (*e.g.,* directly) to the node $T_2$ connected to the measurement circuit 34a and the second terminal of each sense capacitance $C_{S1}$, $C_{S2}$, ... $C_{SM}$ is connected (*e.g.,* directly) to the intermediate node of a respective half-bridge formed by a high-side switch and a low-side switch electronic switches, *i.e.*, half-bridges formed by two electronic switches $M_{21}$ and $M_{41}$, two electronic switches $M_{22}$ and $M_{42}$, etc. Specifically, in the embodiment considered, the various half-bridges are configured to connect the respective intermediate node via a respective high-side switch to the voltage $V_A$ and via the respective low-side switch to the reference voltage $V_{ref}$/ground GND. Accordingly, in the embodiment considered, the measurement system comprises a single half-bridge for the reference capacitance $C_R$ and a respective half-bridge for each of the M sense capacitances $C_{S1}$, $C_{S2}$, ... $C_{SM}$.

Specifically, in order to select a given channel CH, the control terminal of the electronic switches $M_{21}$, $M_{41}$, ...

$M_{2M}$, $M_{4M}$ are selectively connected to the control signals $\Phi_1$ and $\Phi_2$. For example, assuming that the high-side electronic switches $M_{21}$, ... $M_{2M}$ are p-channel FETs and the low-side electronic switches $M_{41}$, ... $M_{4M}$ are n-channel FETs, a given channel CH may be:

- enabled by connecting the gate terminal of the respective high-side electronic switch $M_{21}$, ... $M_{2M}$ to the signal $\overline{\Phi}_1$ and the gate terminal of the respective low-side electronic switch $M_{41}$, ... $M_{4M}$ to the signal $\Phi_2$; and

- disabled by connecting the gate terminal of the respective high-side electronic switch $M_{21}$, ... $M_{2M}$ to a high logic level, such as the supply voltage VDD, and the gate terminal of the respective low-side electronic switch $M_{41}$, ... $M_{4M}$ to a low logic level, such as ground GND.

For example, for this purpose, each high-side electronic switch $M_{21}$, ... $M_{2M}$ has associated a respective electronic switch $SW_{11}$, $SW_{12}$, ... $SW_{1M}$ configured to connect the respective gate terminal to the high logic level or the signal $\overline{\Phi}_1$, and each low-side electronic switch $M_{41}$, ... $M_{4M}$ has associated a respective electronic switch $SW_{21}$, $SW_{22}$, ... $SW_{2M}$ configured to connect the respective gate terminal to the low logic level or the signal $\Phi_2$. For example, the control signal for the electronic switches $SW_{11}$, $SW_{12}$, ... $SW_{1M}$ and $SW_{21}$, $SW_{22}$, ... $SW_{2M}$ may be generated by the control circuit 36a or the processing circuit 44 (not shown in Figure 11). Accordingly, in the embodiment considered, only one of the sense capacitances is usually connected to the terminal $T_2$.

While this embodiment permits to use a single reference capacitance $C_R$, a large loading is applied to the node $T_2$ (*e.g.,* the negative input terminal of the operational amplifier 3440), and a strong capacitive asymmetry is generated between the nodes $T_2$ and $T_4$ (the input terminals of the amplifier 3440).

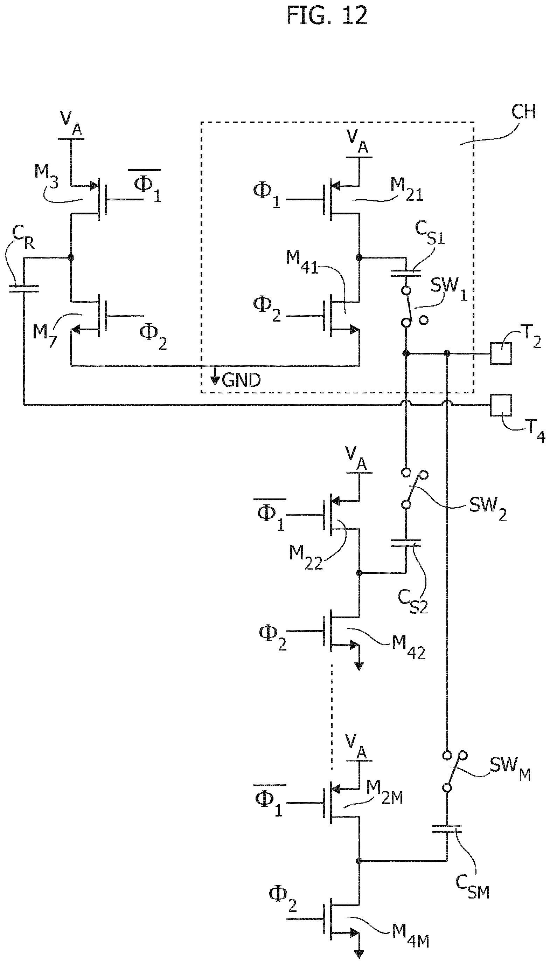

Figure 12 shows thus a slightly different embodiment.

In the embodiment considered, similar to Figure 11, a first terminal of the reference capacitance $C_R$ is again connected (*e.g.,* directly) to the node $T_4$ and the second terminal of the reference capacitance $C_R$ is again connected (*e.g.,* directly) to the intermediate node of the half-bridge formed by the electronic switches $M_1$ and $M_3$. However, this time a first terminal of each sense capacitance $C_{S1}$, $C_{S2}$, ... $C_{SM}$ is connected (*e.g.,* directly) to the intermediate node of a respective half-bridge formed by two electronic switches, i.e., half-bridges formed by two electronic switches $M_{21}$ and $M_{41}$, two electronic switches $M_{22}$ and $M_{42}$, etc., and the second terminal of each sense capacitance $C_{S1}$, $C_{S2}$, ... $C_{SM}$ is connected (*e.g.,* directly) via a respective electronic switch $SW_1$, $SW_2$, ... $SW_M$ to the node $T_2$.

Specifically, in the embodiment considered, the various half-bridges are configured to connect the respective intermediate node to the voltage $V_A$ when the signal $\overline{\Phi}_1$ is asserted and to the reference voltage $V_{ref}$/ground GND when the signal $\Phi_2$ is asserted, *i.e.,* the electronic switches $SW_{11}$, $SW_{21}$, ... $SW_{1M}$, $SW_{2M}$ are omitted. Conversely, each of the electronic switches $SW_1$, $SW_2$, ... $SW_M$ may be driven via a respective control signal in order to connect the respective sense capacitance $C_{S1}$, $C_{S2}$, ... $C_{SM}$ to the respective half-bridge. Thus, by closing one of the electronic switches $SW_1$, $SW_2$, ... $SW_M$ a respective channel CH may be enabled. For example, the control signal for the electronic switches $SW_1$, $SW_2$, ... $SW_M$ may be generated by the control circuit 36a or the processing circuit 44 (not shown in Figure 12). Accordingly, in the embodiment considered, only one of the sense capacitances is usually connected to the terminal $T_2$.

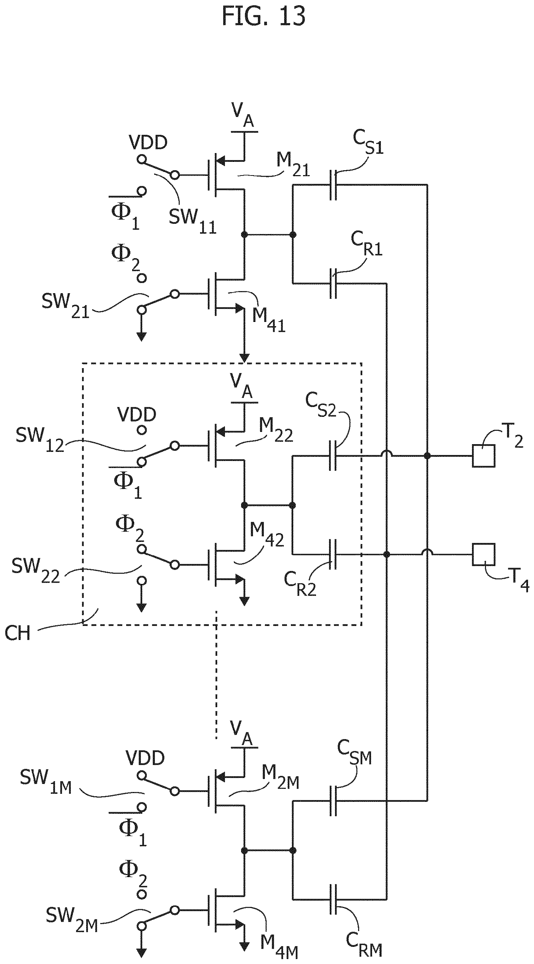

Figure 13 shows an embodiment based on a combination of the embodiments of Figure 8B and 11. Specifically, in this embodiment are used M reference capacitances $C_{R1}$, $C_{R2}$, ... $C_{RM}$ and M sense capacitances $C_{S1}$, $C_{S2}$, ... $C_{SM}$.

Specifically, similar to Figure 8B, in this case, a reference capacitance $C_R$ and a sense capacitance $C_S$ are connected to a respective half-bridge. Specifically, a first terminal of each sense capacitance $C_{S1}$, $C_{S2}$, ... $C_{SM}$ is connected (*e.g.,* directly) to the node $T_2$ and the second terminal of each sense capacitance $C_{S1}$, $C_{S2}$, ... $C_{SM}$ is connected (*e.g.,* directly) to the intermediate node of the respective half-bridge formed by two electronic switches, *i.e.,* half-bridges formed by two electronic switches $M_{21}$ and $M_{41}$, two electronic switches $M_{22}$ and $M_{42}$, etc. Moreover, a first terminal of each reference capacitance $C_{R1}$, $C_{R2}$, ... $C_{RM}$ is connected (*e.g.,* directly) to the node $T_4$ and the second terminal of each reference capacitance $C_{R1}$, $C_{R2}$, ... $C_{RM}$ is connected (*e.g.,* directly) to the intermediate node of the respective half-bridge. Accordingly, in the embodiment considered, the measurement system comprises M half-bridges, one for each channel CH comprising a respective reference capacitance $C_R$ and a respective sense capacitance $C_S$.

In the embodiment considered, similar to Figure 11, each high-side electronic switch $M_{21}$, ... $M_{2M}$ has associated a respective electronic switch $SW_{11}$, $SW_{12}$, ... $SW_{1M}$ configured to connect the respective gate terminal to the high logic level or the signal $\overline{\Phi}_1$, and each low-side electronic switch $M_{41}$, ... $M_{4M}$ has associated a respective electronic switch $SW_{21}$, $SW_{22}$, ... $SW_{2M}$ configured to connect the respective gate terminal to the low logic level or the signal $\Phi_2$. For example, the control signal for the electronic switches $SW_{11}$, $SW_{12}$, ... $SW_{1M}$ and $SW_{21}$, $SW_{22}$, ... $SW_{2M}$ may be generated by the control circuit 36a or the processing circuit 44 (not shown in Figure 13).

Thus, compared to Figure 11, the measurement system has now a rather symmetric capacitive load. However,

13

also in this case, the measurement system has a large loading on the input terminals of the operational amplifier 3440.

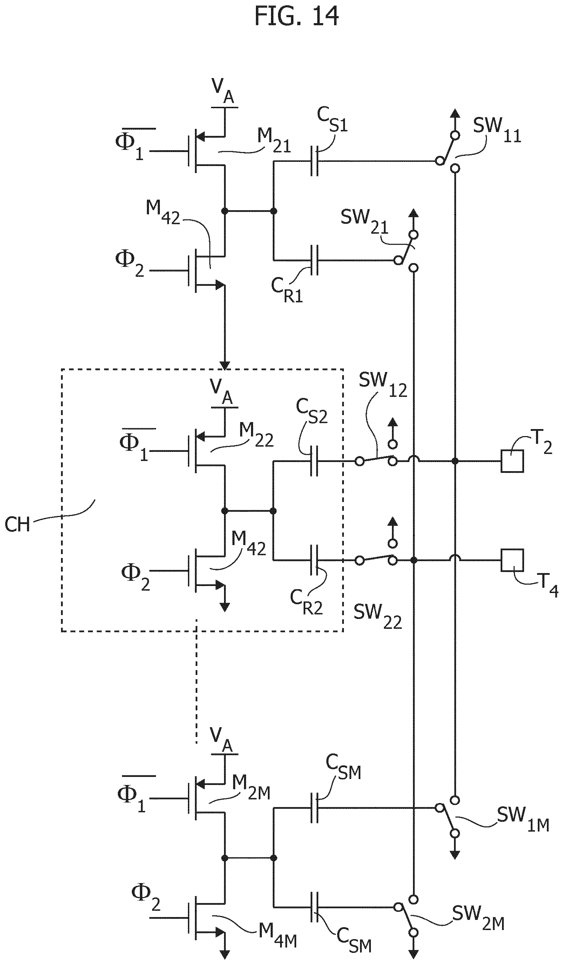

Figure 14 shows thus a slightly different embodiment.

Specifically, a reference capacitance $C_R$ and a sense capacitance $C_S$ are again connected to a respective half-bridge. Specifically, a first terminal of each sense capacitance $C_{S1}$, $C_{S2}$, ... $C_{SM}$ is connected (*e.g.,* directly) to the intermediate node of the respective half-bridge formed by two electronic switches, *i.e.*, half-bridges formed by two electronic switches $M_{21}$ and $M_{41}$, two electronic switches $M_{22}$ and $M_{42}$, etc., and the second terminal of each sense capacitance $C_{S1}$, $C_{S2}$, ... $C_{SM}$ is connected (*e.g.,* directly) via a respective electronic switch $SW_{11}$, $SW_{12}$, ... $SW_{1M}$ to the node $T_2$. Moreover, a first terminal of each reference capacitance $C_{R1}$, $C_{R2}$, ... $C_{RM}$ is connected (*e.g.,* directly) to the intermediate node of the respective half-bridge and the second terminal of each reference capacitance $C_{R1}$, $C_{R2}$, ... $C_{RM}$ is connected (*e.g.,* directly) via a respective electronic switch $SW_{21}$, $SW_{22}$, ... $SW_{2M}$ to the node $T_2$.

Thus, the electronic switches $SW_{11}$, $SW_{12}$, ... $SW_{1M}$ and $SW_{21}$, $SW_{22}$, ... $SW_{2M}$ may be driven via respective control signals in order to connect a single sense capacitance $C_{S1}$, $C_{S2}$, ... $C_{SM}$ and a single reference capacitance $C_{R1}$, $C_{R2}$, ... $C_{RM}$ to the respective half-bridge. For example, the control signals may be generated by the control circuit 36a or the processing circuit 44 (not shown in Figure 14).

In general, the embodiments shown in Figure 11 and 12, and similarly Figures 13 and 14, may also be combined, *i.e.*, the measurement system may comprise electronic switches for selectively connecting the control terminals of the electronic switches $M_{21}$, $M_{41}$, ... $M_{2M}$, $M_{4M}$ to the signals $\overline{\Phi}_1$ and $\Phi_2$ (as shown in Figures 11 and 13) and electronic switches for selectively connecting the sense capacitances to the node $T_2$ (as shown in Figures 12 and 14). Similarly, in case of a plurality of reference capacitances, the measurement system may also comprise electronic switches for selectively connecting the reference capacitances to the node $T_4$ (as shown in Figure 14).

Accordingly, the measurement system 34a disclosed herein may be used to monitor a different charge injected into two capacitances $C_1$ and $C_2$, which in turn may be indicative of a different capacitance value of the two capacitances $C_1$ and $C_2$ or a different voltage $V_1$ and $V_2$ used to charge the capacitances $C_1$ and $C_2$.

For example, in the context of a capacitive sensor, the measurement system may be used to detect the presence of a sample material across an integrated capacitor in a very accurate way. In this case, the sensitivity of the measurement system is mainly determined by the mismatch between the reference and the sensing capacitors.

Compared to the prior art solutions, the detection is very fast. In this respect, the asynchronous detection based on an asynchronous reset via the signal S permits to further increase the speed of the system.

Finally, several simple and low-cost multiplexing solutions available.

Of course, without prejudice to the principle of the invention, the details of construction and the embodiments may vary widely with respect to what has been described and illustrated herein purely by way of example, without thereby departing from the scope of the present invention, as defined by the ensuing claims.

## Claims

1. A measurement system comprising:

   - a first capacitance ($C_1$) and a second capacitance ($C_2$),
   - a switching circuit (32a) configured to receive a first ($\Phi_1$) and a second ($\Phi_2$) control signal and:

     - in response to determining that said first control signal ($\Phi_1$) is asserted, connect a first terminal ($T_1$) of said first capacitance ($C_1$) to a first voltage ($V_1$) and a first terminal ($T_3$) of said second capacitance ($C_2$) to a second voltage ($V_2$), and
     - in response to determining that said second control signal ($\Phi_2$) is asserted, connect said first terminal ($T_1$) of said first capacitance ($C_1$) and said first terminal ($T_3$) of said second capacitance ($C_2$) to a reference voltage ($V_{ref}$);

   - a control circuit (36a) configured to generate said first ($\Phi_1$) and said second ($\Phi_2$) control signal according to switching cycles (Ts), wherein said control circuit (36a) is configured to repeat the following operations during each switching cycle (Ts):

     - for a first interval ($\Delta t_1$), de-assert said first ($\Phi_1$) and said second ($\Phi_2$) control signal,
     - for a following second interval ($\Delta t_2$), de-assert said first control signal ($\Phi_1$) and assert said second control signal ($\Phi_2$),
     - for a following third interval ($\Delta t_3$), de-assert said first ($\Phi_1$) and said second ($\Phi_2$) control signal, and
     - for a following fourth interval ($\Delta t_4$), assert said first control signal ($\Phi_1$) and de-assert said second control

signal ($\Phi_2$);

wherein said measurement system comprises further a measurement circuit (34a), said measurement circuit (34a) comprising:

- a differential integrator comprising:

    - a differential operational amplifier (3440), wherein an inverting input of said differential operational amplifier (3440) is connected to a second terminal ($T_2$) of said first capacitance ($C_1$) and a non-inverting input of said differential operational amplifier (3440) is connected to a second terminal ($T_4$) of said second capacitance ($C_2$),

    - a first integration capacitance ($C_{I1}$), wherein a first terminal of said first integration capacitance ($C_{I1}$) is connected to said inverting input of said differential operational amplifier (3440) and a second terminal of said first integration capacitance ($C_{I1}$) is connected via a first electronic switch (3448) to a positive output terminal of said differential operational amplifier (3440), wherein said second terminal of said first integration capacitance ($C_{I1}$) represents a first output node (OUT+) of said differential integrator,

    - a second integration capacitance ($C_{I2}$), wherein a first terminal of said second integration capacitance ($C_{I2}$) is connected to said non-inverting input of said differential operational amplifier (3440) and a second terminal of said second integration capacitance ($C_{I2}$) is connected via a second electronic switch (3450) to a negative output terminal of said differential operational amplifier (3440), wherein said second terminal of said second integration capacitance ($C_{I2}$) represents a second output node (OUT-) of said differential integrator,

    - a third electronic switch (3452) connected between said inverting input of said differential operational amplifier (3440) and said positive output terminal of said operational amplifier (3440), and

    - a fourth electronic switch (3454) connected between said non-inverting input of said differential operational amplifier (3440) and said negative output terminal of said operational amplifier (3440);

- a comparator with hysteresis (3446) configured to, in response to determining that a voltage applied to a negative input terminal of said comparator with hysteresis (3446) exceeds a voltage applied to a positive input terminal of said comparator with hysteresis (3446) plus a hysteresis threshold, assert a signal (S);

wherein said measurement system is configured to:

- during a normal operation phase:

    - close said first electronic switch (3448) and said second electronic switch (3450) in response to determining that said second control signal ($\Phi_2$) is asserted, and open said first electronic switch (3448) and said second electronic switch (3450) in response to determining that said second control signal ($\Phi_2$) is de-asserted,

    - close said third electronic switch (3452) and said fourth electronic switch (3454) in response to determining that said first control signal ($\Phi_1$) is asserted, and open said third electronic switch (3452) and said fourth electronic switch (3454) in response to determining that said first control signal ($\Phi_1$) is de-asserted.

2. The measurement system according to Claim 1, comprising:

- a first decoupling capacitance ($C_{DEC1}$) connected between a negative input of said comparator with hysteresis (3446) and said first output node (OUT+) of said differential integrator, and a second decoupling capacitance ($C_{DEC2}$) connected between a positive input of said comparator with hysteresis (3446) and said second output node (OUT-) of said differential integrator.

3. The measurement system according to Claim 1 or Claim 2, wherein said comparator with hysteresis (3446) is configured to, in response to determining that a voltage applied to a negative input terminal of said comparator with hysteresis (3446) exceeds a voltage applied to a positive input terminal of said comparator with hysteresis (3446) plus a hysteresis threshold, set a first output terminal (OUT) of said comparator with hysteresis (3446) to high a second output terminal (OUTN) of said comparator with hysteresis (3446) to low.

4. The measurement system according to Claim 3, wherein said comparator with hysteresis (3446) comprises:

- a fifth electronic switch (3464) connected between said negative input of said comparator with hysteresis (3446) and said second output terminal (OUTN) of said comparator with hysteresis (3446), and
- a sixth electronic switch (3466) connected between said positive input of said comparator with hysteresis (3446) and said first output terminal (OUT) of said comparator with hysteresis (3446);

wherein said measurement system is configured to:

- during a normal operation phase:

- open said fifth electronic switch (3464) and said sixth electronic switch (3466).

5. The measurement system according to a combination of Claims 2 and 4, wherein said measurement system is configured to:

- during a normal operation phase:

- monitor a reset request signal (S; Reset1) indicating a reset request and start a reset phase in response to determining that said reset request signal indicates a reset request; and

- during said reset phase:

- for a first reset interval ($t_1$-$t_2$), close said first (3448), second (3450), third (3452), fourth (3454), fifth (3464) and sixth (3466) electronic switches, and
- start again said normal operation phase.

6. The measurement system according to Claim 5, wherein said measurement system is configured to:

- during said reset phase:

- for a second reset interval ($t_2$-$t_3$) following said first reset interval ($t_1$-$t_2$), open said third (3452) and fourth (3454) electronic switches and keep closed said first (3448), second (3450), fifth (3464) and sixth (3466) electronic switches.

7. The measurement system according to Claim 6,

wherein said differential integrator is configured to receive a first reset signal (Reset1), wherein said third electronic switch (3452) and said fourth electronic switch (3454) are configured to be closed in response to determining (3442, 3444) that said first control signal ($\Phi_1$) is asserted or said first reset signal (Reset1) is asserted; wherein said comparator with hysteresis (3446) is configured to receive a second reset signal (Reset2), wherein said fifth electronic switch (3464) and said sixth electronic switch (3466) are configured to be closed in response to determining that said second reset signal (Reset2) is asserted; and wherein said measurement system is configured to, while said second control signal ($\Phi_2$) is asserted:

- for said first reset interval ($t_1$-$t_2$), assert said first reset signal (Reset1) and said second reset signal (Reset2), and
- for said second reset interval ($t_2$-$t_3$), de-assert said first reset signal (Reset1) and assert said second reset signal (Reset2).

8. The measurement system according to Claim 7, comprising a delay circuit (3456, 3458) configured to generate said second reset signal (Reset2) by delaying ($t_D$) said first reset signal (Reset1).

9. The measurement system according to any of the previous claims 5 to 8, wherein said measurement system is configured to assert said reset request signal after a given maximum number of said switching cycles ($T_S$).

10. The measurement system according to any of the previous claims 5 to 9, wherein said measurement system is configured to assert said reset request signal in response to determining that said first output terminal (OUT) of said comparator with hysteresis (3446) is set to high and/or said second output terminal (OUTN) of said comparator with hysteresis (3446) is set to low.

**11.** The measurement system according to any of the previous claims 3 to 10, comprising a processing circuit (44) configured to monitor a signal (S) at said first output terminal (OUT) of said comparator with hysteresis (3446) and/or said second output terminal (OUTN) of said comparator with hysteresis (3446).

**12.** The measurement system according to any of the previous claims, wherein said first capacitance ($C_1$) corresponds to a sense capacitance ($C_S$) and said second capacitance ($C_2$) corresponds to a reference capacitance ($C_R$), and wherein said first voltage ($V_1$) and said second voltage ($V_2$) have a common voltage ($V_A$), whereby the voltage between the first (OUT+) and second (OUT-) output nodes of said differential integrator is indicative of the difference between the capacitances of said sense capacitance ($C_S$) and said reference capacitance ($C_R$).

**13.** The measurement system according to Claim 12, comprising a voltage generator (42) configured to generate said common voltage ($V_A$).

**14.** The measurement system according to Claim 12 or Claim 13, comprising a plurality of sense capacitance ($C_{S1},...C_{SM}$), wherein said switching circuit (32a) comprises for each sense capacitance ($C_{S1},...C_{SM}$) a respective half-bridge, wherein each half-bridge comprises a high-side electronic switch ($M_{21},...M_{2M}$) connected between said common voltage ($V_A$) and a first terminal ($T_1$) of the respective sense capacitance ($C_{S1},...C_{SM}$), and a low-side electronic switch ($M_{41},...M_{4M}$) connected between said reference voltage ($V_{ref}$) and the first terminal ($T_1$) of the respective sense capacitance ($C_{S1},...C_{SM}$), and wherein said switching circuit (32a) comprises:

- for each sense capacitance ($C_{S1},...C_{SM}$) a respective electronic switch ($SW_1,...SW_M$) configured to selectively connect a second terminal ($T_2$) of the respective sense capacitance ($C_{S1},...C_{SM}$) to said inverting input of said differential operational amplifier (3440); and/or
- for each sense capacitance ($C_{S1},...C_{SM}$) a respective electronic switch ($SW_{11},...SW_{1M}$) configured to selectively connect a control terminal of the respective high-side electronic switch ($M_{21},...M_{2M}$) to said first control signal ($\Phi_1$) or a voltage (VDD) arranged to maintain opened the respective high-side electronic switch ($M_{21},...M_{2M}$) and a respective electronic switch ($SW_{21},...SW_{2M}$) configured to selectively connect a control terminal of the respective low-side electronic switch ($M_{41},...M_{4M}$) to said second control signal ($\Phi_2$) or a voltage (GND) arranged to maintain opened the respective low-side electronic switch ($M_{41},...M_{4M}$).

**15.** The measurement system according to Claim 14, comprising a single reference capacitance ($C_R$), wherein said switching circuit (32a) comprises a further half-bridge comprising a further high-side electronic switch ($M_1$) connected between said common voltage ($V_A$) and a first terminal ($T_3$) of the reference capacitance ($C_R$), and a further low-side electronic switch ($M_3$) connected between said reference voltage ($V_{ref}$) and the first terminal ($T_4$) of said reference capacitance ($C_R$).

**16.** The measurement system according to Claim 14, comprising for each sense capacitance ($C_{S1},...C_{SM}$) a respective reference capacitance ($C_{R1},...C_{RM}$), wherein a first terminal of each reference capacitance ($C_{R1},...C_{RM}$) is connected to the first terminal of the respective sense capacitance ($C_{S1},...C_{SM}$).

**17.** The measurement system according to any of the previous claims 1 to 11, wherein said first capacitance ($C_1$) and said second capacitance ($C_2$) have the same capacitance value ($C_S$), whereby the voltage between the first (OUT+) and second (OUT-) output nodes of said differential integrator is indicative of the difference between said first voltage ($V_1$; $V_{in+}$) and said second voltage ($V_2$; $V_{in-}$).

**18.** An integrated circuit (40) comprising a measurement system according to any of the previous claims.

**19.** A method of operating a measurement system according to any of the previous claims 1 to 17, comprising:

- during a normal operation phase:

- closing said first electronic switch (3448) and said second electronic switch (3450) in response to determining that said second control signal ($\Phi_2$) is asserted, and opening said first electronic switch (3448) and said second electronic switch (3450) in response to determining that said second control signal ($\Phi_2$) is de-asserted,
- closing said third electronic switch (3452) and said fourth electronic switch (3454) in response to determining that said first control signal ($\Phi_1$) is asserted, and opening said third electronic switch (3452) and said fourth electronic switch (3454) in response to determining that said first control signal ($\Phi_1$) is de-asserted.

**20.** The method according to Claim 19, comprising:

- during said normal operation phase:

  - opening said fifth electronic switch (3464) and said sixth electronic switch (3466), and
  - monitoring a reset request signal (S; Reset1) indicating a reset request and starting a reset phase in response to determining that said reset request signal indicates a reset request;

- during said reset phase:

  - for a first reset interval ($t_1$-$t_2$), closing said first (3448), second (3450), third (3452), fourth (3454), fifth (3464) and sixth (3466) electronic switches, and
  - starting again said normal operation phase.

**Patentansprüche**

**1.** Messsystem, umfassend:

- eine erste Kapazität ($C_1$) und eine zweite Kapazität ($C_2$),
- einen Schaltstromkreis (32a), der konfiguriert ist, um ein erstes ($\Phi_1$) und ein zweites ($\Phi_2$) Steuersignal zu empfangen, und:

  - als Reaktion auf das Bestimmen, dass das erste Steuersignal ($\Phi_1$) aktiviert ist, Verbinden eines ersten Anschlusses ($T_1$) der ersten Kapazität ($C_1$) mit einer ersten Spannung ($V_1$) und eines ersten Anschlusses ($T_3$) der zweiten Kapazität ($C_2$) mit einer zweiten Spannung ($V_2$), und
  - als Reaktion auf das Bestimmen, dass das zweite Steuersignal ($\Phi_2$) aktiviert ist, Verbinden des ersten Anschlusses ($T_1$) der ersten Kapazität ($C_1$) und des ersten Anschlusses ($T_3$) der zweiten Kapazität ($C_2$) mit einer Referenzspannung ($V_{ref}$);

- einen Steuerstromkreis (36a), der konfiguriert ist, um das erste ($\Phi_1$) und das zweite ($\Phi_2$) Steuersignal gemäß Schaltzyklen ($T_S$) zu erzeugen, wobei der Steuerstromkreis (36a) konfiguriert ist, um die folgenden Operationen während jedem Schaltzyklus ($T_S$) zu wiederholen:

  - für ein erstes Intervall ($\Delta t_1$), Deaktivieren des ersten ($\Phi_1$) und des zweiten ($\Phi_2$) Steuersignals,
  - für ein folgendes zweites Intervall ($\Delta t_2$), Deaktivieren des ersten Steuersignals ($\Phi_1$) und Aktivieren des zweiten Steuersignals ($\Phi_2$),
  - für ein folgendes drittes Intervall ($\Delta t_3$), Deaktivieren des ersten ($\Phi_1$) und des zweiten ($\Phi_2$) Steuersignals, und
  - für ein folgendes viertes Intervall ($\Delta t_4$), Aktivieren des ersten Steuersignals ($\Phi_1$) und Deaktivieren des zweiten Steuersignals ($\Phi_2$);

wobei das Messsystem ferner einen Messstromkreis (34a) umfasst, wobei der Messstromkreis (34a) umfasst:

- einen Differenz-Integrator, umfassend:

  - einen Differenz-Operationsverstärker (3440), wobei ein invertierender Eingang des Differenz-Operationsverstärkers (3440) mit einem zweiten Anschluss ($T_2$) der ersten Kapazität ($C_1$) verbunden ist und ein nichtinvertierender Eingang des Differenz-Operationsverstärkers (3440) mit einem zweiten Anschluss ($T_4$) der zweiten Kapazität ($C_2$) verbunden ist,
  - eine erste Integrations-Kapazität ($C_{11}$), wobei ein erster Anschluss der ersten Integrations-Kapazität ($C_{11}$) mit dem invertierenden Eingang des Differenz-Operationsverstärkers (3440) verbunden ist und ein zweiter Anschluss der ersten Integrations-Kapazität ($C_{11}$) über einen ersten elektronischen Schalter (3448) mit einem positiven Ausgangsanschluss des Differenz-Operationsverstärkers (3440) verbunden ist, wobei der zweite Anschluss der ersten Integrations-Kapazität ($C_{11}$) einen ersten Ausgangsknoten (OUT+) des Differenz-Integrators darstellt,
  - eine zweite Integrations-Kapazität ($C_{12}$), wobei ein erster Anschluss der zweiten Integrations-Kapazität ($C_{12}$) mit dem nicht-invertierenden Eingang des Differenz-Operationsverstärkers (3440) verbunden ist und ein zweiter Anschluss der zweiten Integrations-Kapazität ($C_{12}$) über einen zweiten elektronischen Schalter (3450) mit einem negativen Ausgangsanschluss des Differenz-Operationsverstärkers (3440) verbunden ist, wobei der zweite Anschluss der zweiten Integrations-Kapazität ($C_{12}$) einen zweiten Ausgangsknoten (OUT-) des Differenz-Integrators darstellt,

- einen dritten elektronischen Schalter (3452), der zwischen dem invertierenden Eingang des Differenz-Operationsverstärkers (3440) und dem positiven Ausgangsanschluss des Operationsverstärkers (3440) verbunden ist, und

- einen vierten elektronischen Schalter (3454), der zwischen dem nicht-invertierenden Eingang des Differenz-Operationsverstärker (3440) und dem negativen Ausgangsanschluss des Operationsverstärkers (3440) verbunden ist;

- einen Komparator mit Hysterese (3446), der konfiguriert ist, um, als Reaktion auf das Bestimmen, dass eine Spannung, die an einen negativen Eingangsanschluss des Komparators mit Hysterese (3446) angelegt ist, eine Spannung überschreitet, die an einen positiven Eingangsanschluss des Komparators mit Hysterese (3446) angelegt ist, plus einen Hysterese-Schwellenwert, ein Signal (S) zu aktivieren;

wobei das Messsystem konfiguriert ist zum:

- während einer normalen Betriebsphase:

- Schließen des ersten elektronischen Schalters (3448) und des zweiten elektronischen Schalters (3450) als Reaktion auf das Bestimmen, dass das zweite Steuersignal ($\Phi_2$) aktiviert ist, und Öffnen des ersten elektronischen Schalters (3448) und des zweiten elektronischen Schalters (3450) als Reaktion auf das Bestimmen, dass das zweite Steuersignal ($\Phi_2$) deaktiviert ist,

- Schließen des dritten elektronischen Schalters (3452) und des vierten elektronischen Schalters (3454) als Reaktion auf das Bestimmen, dass das erste Steuersignal ($\Phi_1$) aktiviert ist, und Öffnen des dritten elektronischen Schalters (3452) und des vierten elektronischen Schalters (3454) als Reaktion auf das Bestimmen, dass das erste Steuersignal ($\Phi_1$) deaktiviert ist.

2. Messsystem nach Anspruch 1, umfassend:

- eine erste Entkopplungskapazität ($C_{DEC1}$), die zwischen einem negativen Eingang des Komparators mit Hysterese und dem ersten Ausgangsknoten (OUT+) des Differenz-Integrators verbunden ist, und eine zweite Entkopplungskapazität ($C_{DEC2}$), die zwischen einem positiven Eingang des Komparators mit Hysterese (3446) und dem zweiten Ausgangsknoten (OUT-) des Differenz-Integrators verbunden ist.

3. Messsystem nach Anspruch 1 oder Anspruch 2, wobei der Komparator mit Hysterese (3446) konfiguriert ist, um, als Reaktion auf das Bestimmen, dass eine Spannung, die an einen negativen Eingangsanschluss des Komparators mit Hysterese (3446) angelegt ist, eine Spannung überschreitet, die an einen positiven Eingangsanschluss des Komparators mit Hysterese (3446) angelegt ist, plus einen Hysterese-Schwellenwert, einen ersten Ausgangsanschlusses (OUT) des Komparators mit Hysterese (3446) auf High und einen zweiten Ausgangsanschluss (OUTN) des Komparators mit Hysterese auf Low zu setzen.

4. Messsystem nach Anspruch 3, wobei der Komparator mit Hysterese (3446) umfasst:

- einen fünften elektronischen Schalter (3464), der zwischen dem negativen Eingang des Komparators mit Hysterese (3446) und dem zweiten Ausgangsanschluss (OUTN) des Komparators mit Hysterese (3446) verbunden ist, und

- einen sechsten elektronischen Schalter (3466), der zwischen dem positiven Eingang des Komparators mit Hysterese (3446) und dem ersten Ausgangsanschluss (OUT) des Komparators mit Hysterese (3446) verbunden ist;

wobei das Messsystem konfiguriert ist zum:

- während einer normalen Betriebsphase:

- Öffnen des fünften elektronischen Schalters (3464) und des sechsten elektronischen Schalters (3466).

5. Messsystem nach einer Kombination der Ansprüche 2 und 4, wobei das Messsystem konfiguriert ist zum:

- während einer normalen Betriebsphase:

- Überwachen eines Rücksetzanforderungssignals (S; Reset1), das eine Rücksetzanforderung anzeigt, und Starten einer Rücksetzphase als Reaktion auf das Bestimmen, dass das Rücksetzanforderungssignal eine Rücksetzanforderung anzeigt; und

- während der Rücksetzphase:

- für ein erstes Rücksetzintervall ($t_1$-$t_2$), Schließen des ersten (3448), zweiten (3450), dritten (3452), vierten (3454), fünften (3464) und sechsten (3466) elektronischen Schalters, und
- erneutes Starten der normalen Betriebsphase.

6. Messsystem nach Anspruch 5, wobei das Messsystem konfiguriert ist zum:

- während der Rücksetzphase:

- für ein zweites Rücksetzintervall ($t_2$-$t_3$), das auf das erste Rücksetzintervall ($t_1$-$t_2$) folgt, Öffnen des dritten (3452) und vierten (3454) elektronischen Schalters, und Geschlossen-halten des ersten (3448), zweiten (3450), fünften (3464) und sechsten (3466) elektronischen Schalters.

7. Messsystem nach Anspruch 6,

wobei der Differenz-Integrator konfiguriert ist, um ein erstes Rücksetzsignal (Reset1) zu empfangen, wobei der dritte elektronische Schalter (3452) und der vierte elektronische Schalter (3454) konfiguriert sind, um, als Reaktion auf das Bestimmen (3442, 3444), dass das erste Steuersignal ($\Phi_1$) aktiviert ist oder das erste Rücksetzsignal (Reset1) aktiviert ist, geschlossen zu werden;
wobei der Komparator mit Hysterese (3446) konfiguriert ist, um ein zweites Rücksetzsignal (Reset2) zu empfangen, wobei der fünfte elektronische Schalter (3464) und der sechste elektronische Schalter (3466) konfiguriert sind, um, als Reaktion auf das Bestimmen, dass das zweite Rücksetzsignal (Reset2) aktiviert ist, geschlossen zu werden; und
wobei das Messsystem konfiguriert ist, zum, solange das zweite Steuersignal ($\Phi_2$) aktiviert ist:

- für das erste Rücksetzintervall ($t_1$-$t_2$), Aktivieren des ersten Rücksetzsignals (Reset1) und des zweiten Rücksetzsignals (Reset2), und
- für das zweite Rücksetzintervall ($t_2$-$t_3$), Deaktivieren des ersten Rücksetzsignals (Reset1) und Aktivieren des zweiten Rücksetzsignals (Reset2).

8. Messsystem nach Anspruch 7, einen Verzögerungsstromkreis (3456, 3458) umfassend, der konfiguriert ist, um das zweite Rücksetzsignal (Reset2) durch Verzögern ($t_D$) des ersten Rücksetzsignals (Reset1) zu erzeugen.

9. Messsystem nach einem der vorhergehenden Ansprüche 5 bis 8, wobei das Messsystem konfiguriert ist, um das Rücksetzanforderungssignal nach einer gegebenen maximalen Anzahl der Schaltzyklen ($T_S$) zu aktivieren.

10. Messsystem nach einem der vorhergehenden Ansprüche 5 bis 9, wobei das Messsystem konfiguriert ist, um das Rücksetzanforderungssignal zu aktivieren als Reaktion auf das Bestimmen, dass der erste Ausgangsanschluss (OUT) des Komparators mit Hysterese (3446) auf High gesetzt ist und/oder der zweite Ausgangsanschluss (OUTN) des Komparators mit Hysterese (3446) auf Low gesetzt ist.

11. Messsystem nach einem der vorhergehenden Ansprüche 3 bis 10, einen Verarbeitungsstromkreis (44) umfassend, der konfiguriert ist, um ein Signal (S) am ersten Ausgangsanschluss (OUT) des Komparators mit Hysterese zu überwachen und/oder am zweiten Ausgangsanschluss (OUTN) des Komparators mit Hysterese (3446).

12. Messsystem nach einem der vorhergehenden Ansprüche, wobei die erste Kapazität ($C_1$) einer Abtastkapazität ($C_S$) entspricht und die zweite Kapazität ($C_2$) einer Referenzkapazität ($C_R$) entspricht, und wobei die erste Spannung ($V_1$) und die zweite Spannung ($V_2$) eine gemeinsame Spannung ($V_A$) aufweisen, wobei die Spannung zwischen dem ersten (OUT+) und dem zweiten (OUT-) Ausgangsknoten des Differenz-Integrators die Differenz zwischen den Kapazitäten der Abtastkapazität ($C_S$) und der Referenzkapazität ($C_R$) anzeigt.

**13.** Messsystem nach Anspruch 12, einen Spannungsgenerator (42) umfassend, der konfiguriert ist, um die gemeinsame Spannung ($V_A$) zu erzeugen.

**14.** Messsystem nach Anspruch 12 oder Anspruch 13, eine Vielzahl von Abtastkapazitäten (Csm ... $C_{SM}$) umfassend, wobei der Schaltstromkreis (32a) für jede Abtastkapazität ($C_{S1}$, ... $C_{SM}$) eine entsprechende Halbbrücke umfasst, wobei jede Halbbrücke einen elektronischen High-Side-Schalter ($M_{21}$, ... $M_{2M}$) umfasst, der zwischen der gemeinsamen Spannung ($V_A$) und einem ersten Anschluss ($T_1$) der entsprechenden Abtastkapazität ($C_{S1}$,... $C_{SM}$) verbunden ist, und einen elektronischen Low-Side-Schalter ($M_{41}$,... $M_{4M}$), der zwischen der Referenzspannung ($V_{ref}$) und dem ersten Anschluss ($T_1$) der entsprechenden Abtastkapazität (Csi, ... $C_{SM}$) verbunden ist, und wobei der Schaltstromkreis (32a) umfasst:

- für jede Abtastkapazität ($C_{S1}$,... $C_{SM}$) einen entsprechenden elektronischen Schalter ($SW_1$,... $SW_M$), der konfiguriert ist, um selektiv einen zweiten Anschluss ($T_2$) der entsprechenden Abtastkapazität ($C_{S1}$,... $C_{SM}$) mit dem invertierenden Eingang des Differenz-Operationsverstärkers (3440) zu verbinden; und/oder
- für jede Abtastkapazität ($C_{S1}$, ... $C_{SM}$) einen entsprechenden elektronischen Schalter ($SW_{11}$,... $SW_{1M}$), der konfiguriert ist, um selektiv einen Steueranschluss des entsprechenden elektronischen High-Side-Schalters ($M_{21}$,... $M_{2M}$) mit dem ersten Steuersignal ($\Phi_1$) zu verbinden oder einer Spannung (VDD), die angeordnet ist, um den entsprechenden elektronischen High-Side-Schalter ($M_{21}$, ... $M_{2M}$) geöffnet zu halten, und einen entsprechenden elektronischen Schalter ($SW_{21}$, ... $SW_{2M}$), der konfiguriert ist, um selektiv einen Steueranschluss des entsprechenden elektronischen Low-Side-Schalters ($M_{41}$,... $M_{4M}$) mit dem zweiten Steuersignal ($\Phi_2$) zu verbinden oder einer Spannung (GND), die angeordnet ist, um den entsprechenden elektronischen Low-Side-Schalter ($M_{41}$,... $M_{4M}$) geöffnet zu halten.

**15.** Messsystem nach Anspruch 14, eine einzelne Referenzkapazität ($C_R$) umfassend, wobei der Schaltstromkreis (32a) eine weitere Halbbrücke umfasst, die einen weiteren elektronischen High-Side-Schalter ($M_1$) umfasst, der zwischen der gemeinsamen Spannung ($V_A$) und einem ersten Anschluss ($T_3$) der Referenzkapazität ($C_R$) verbunden ist, und einen weiteren elektronischen Low-Side-Schalter ($M_3$), der zwischen der Referenzspannung ($V_{ref}$) und dem ersten Anschluss ($T_4$) der Referenzkapazität ($C_R$) verbunden ist.

**16.** Messsystem nach Anspruch 14, das für jede Abtastkapazität ($C_{S1}$, ... $C_{SM}$) eine entsprechende Referenzkapazität ($C_{R1}$,... $C_{RM}$) umfasst, wobei ein erster Anschluss jeder Referenzkapazität ($C_{R1}$,... $C_{RM}$) mit dem ersten Anschluss der entsprechenden Abtastkapazität ($C_{S1}$, ... $C_{SM}$) verbunden ist.

**17.** Messsystem nach einem der vorhergehenden Ansprüche 1 bis 11, wobei die erste Kapazität ($C_1$) und die zweite Kapazität ($C_2$) den gleichen Kapazitätswert ($C_S$) aufweisen, wobei die Spannung zwischen dem ersten (OUT+) und dem zweiten (OUT-) Ausgangsknoten des Differenz-Integrators die Differenz zwischen der ersten Spannung ($V_1$; $V_{in+}$) und der zweiten Spannung ($V_2$; $V_{in-}$) anzeigt.

**18.** Integrierter Stromkreis (40), ein Messsystem nach einem der vorhergehenden Ansprüche umfassend.

**19.** Verfahren zum Betreiben eines Messsystems nach einem der vorhergehenden Ansprüche 1 bis 17, umfassend:

- während einer normalen Betriebsphase:

- Schließen des ersten elektronischen Schalters (3448) und des zweiten elektronischen Schalters (3450) als Reaktion auf das Bestimmen, dass das zweite Steuersignal ($\Phi_2$) aktiviert ist, und Öffnen des ersten elektronischen Schalters (3448) und des zweiten elektronischen Schalters (3450) als Reaktion auf das Bestimmen, dass das zweite Steuersignal ($\Phi_2$) deaktiviert ist,
- Schließen des dritten elektronischen Schalters (3452) und des vierten elektronischen Schalters (3454) als Reaktion auf das Bestimmen, dass das erste Steuersignal ($\Phi_1$) aktiviert ist, und Öffnen des dritten elektronischen Schalters (3452) und des vierten elektronischen Schalters (3454) als Reaktion auf das Bestimmen, dass das erste Steuersignal ($\Phi_1$) deaktiviert ist.

**20.** Verfahren nach Anspruch 19, umfassend:

- während der normalen Betriebsphase:

- Öffnen des fünften elektronischen Schalters (3464) und des sechsten elektronischen Schalters (3466), und

- Überwachen eines Rücksetzanforderungssignals (S; Reset1), das eine Rücksetzanforderung anzeigt, und Starten einer Rücksetzphase als Reaktion auf das Bestimmen, dass das Rücksetzanforderungssignal eine Rücksetzanforderung anzeigt;

- während der Rücksetzphase:

- für ein erstes Rücksetzintervall ($t_1$-$t_2$), Schließen des ersten (3448), zweiten (3450), dritten (3452), vierten (3454), fünften (3464) und sechsten (3466) elektronischen Schalters, und
- erneutes Starten der normalen Betriebsphase.

**Revendications**

1. Système de mesure comprenant :

- un premier condensateur ($C_1$) et un deuxième condensateur ($C_2$),
- un circuit de commutation (32a) configuré pour recevoir un premier ($\Phi_1$) et un deuxième ($\Phi_2$) signal de commande et :

- en réponse à la détermination que ledit premier signal de commande ($\Phi_1$) est activé, connecter une première borne ($T_1$) dudit premier condensateur ($C_1$) à une première tension ($V_1$) et une première borne ($T_3$) dudit deuxième condensateur ($C_2$) à une deuxième tension ($V_2$), et
- en réponse à la détermination que ledit deuxième signal de commande ($\Phi_2$) est activé, connecter ladite première borne ($T_1$) dudit premier condensateur ($C_1$) et ladite première borne ($T_3$) dudit deuxième condensateur ($C_2$) à une tension de référence ($V_{ref}$) ;
- un circuit de commande (36a) configuré pour générer ledit premier ($\Phi_1$) et ledit deuxième ($\Phi_2$) signal de commande selon des cycles de commutation ($T_S$), dans lequel ledit circuit de commande (36a) est configuré pour répéter les opérations suivantes au cours de chaque cycle de commutation ($T_S$) :

- pendant un premier intervalle ($\Delta t_1$), désactiver ledit premier ($\Phi_1$) et ledit deuxième ($\Phi_2$) signal de commande,
- pendant un deuxième intervalle ($\Delta t_2$) suivant, désactiver ledit premier signal de commande ($\Phi_1$) et activer ledit deuxième signal de commande ($\Phi_2$),
- pendant un troisième intervalle ($\Delta t_3$) suivant, désactiver ledit premier ($\Phi_1$) et ledit deuxième ($\Phi_2$) signal de commande, et
- pendant un quatrième intervalle ($\Delta t_4$) suivant, activer ledit premier signal de commande ($\Phi_1$) et désactiver ledit deuxième signal de commande ($\Phi_2$) ;

dans lequel ledit système de mesure comprend en outre un circuit de mesure (34a), ledit circuit de mesure (34a) comprenant :

- un intégrateur différentiel comprenant :

- un amplificateur opérationnel différentiel (3440), dans lequel une entrée inverseuse dudit amplificateur opérationnel différentiel (3440) est connectée à une deuxième borne ($T_2$) dudit premier condensateur ($C_1$) et une entrée non inverseuse dudit amplificateur opérationnel différentiel (3440) est connectée à une deuxième borne ($T_4$) dudit deuxième condensateur ($C_2$),
- un premier condensateur d'intégration ($C_{I1}$), dans lequel une première borne dudit premier condensateur d'intégration ($C_{I1}$) est connectée à ladite entrée inverseuse dudit amplificateur opérationnel différentiel (3440) et une deuxième borne dudit premier condensateur d'intégration ($C_{I1}$) est connectée via un premier commutateur électronique (3448) à une borne de sortie positive dudit amplificateur opérationnel différentiel (3440), dans lequel ladite deuxième borne dudit premier condensateur d'intégration ($C_{I1}$) représente un premier nœud de sortie (OUT+) dudit intégrateur différentiel,
- un deuxième condensateur d'intégration ($C_{I2}$),

dans lequel une première borne dudit deuxième condensateur d'intégration ($C_{I2}$) est connectée à ladite entrée non inverseuse dudit amplificateur opérationnel différentiel (3440) et une deuxième borne dudit deuxième condensateur d'intégration ($C_{I2}$) est connectée via un deuxième commutateur électronique (3450) à une borne de sortie négative dudit amplificateur opérationnel différentiel (3440), dans lequel ladite deuxième borne dudit deuxième condensateur d'intégration ($C_{I2}$) représente un deuxième noeud de sortie (OUT-) dudit intégrateur différentiel,

- un troisième commutateur électronique (3452) connecté entre ladite entrée inverseuse dudit amplificateur opérationnel différentiel (3440) et ladite borne de sortie positive dudit amplificateur opérationnel (3440), et
- un quatrième commutateur électronique (3454) connecté entre ladite entrée non inverseuse dudit amplificateur opérationnel différentiel (3440) et ladite borne de sortie négative dudit amplificateur opérationnel (3440) ;
- un comparateur à hystérésis (3446) configuré pour, en réponse à la détermination qu'une tension appliquée sur une borne d'entrée négative dudit comparateur à hystérésis dépasse une tension appliquée sur une borne d'entrée positive dudit comparateur à hystérésis (3446) plus un seuil d'hystérésis, activer un signal (S) ;

dans lequel ledit système de mesure est configuré pour :

- au cours d'une phase d'opération normale :

- fermer ledit premier commutateur électronique (3448) et ledit deuxième commutateur électronique (3450) en réponse à la détermination que ledit deuxième signal de commande ($\Phi_2$) est activé, et ouvrir ledit premier commutateur électronique (3448) et ledit deuxième commutateur électronique (3450) en réponse à la détermination que ledit deuxième signal de commande ($\Phi_2$) est désactivé,
- fermer ledit troisième commutateur électronique (3452) et ledit quatrième commutateur électronique (3454) en réponse à la détermination que ledit premier signal de commande ($\Phi_1$) est activé, et ouvrir ledit troisième commutateur électronique (3452) et ledit quatrième commutateur électronique (3454) en réponse à la détermination que ledit premier signal de commande ($\Phi_1$) est désactivé.

2. Système de mesure selon la revendication 1, comprenant :

- un premier condensateur de découplage ($C_{DEC1}$) connecté entre une entrée négative dudit comparateur à hystérésis et ledit premier noeud de sortie (OUT+) dudit intégrateur différentiel, et un deuxième condensateur de découplage ($C_{DEC2}$) connecté entre une entrée positive dudit comparateur à hystérésis (3446) et ledit deuxième noeud de sortie (OUT-) dudit intégrateur différentiel.

3. Système de mesure selon la revendication 1 ou la revendication 2, dans lequel ledit comparateur à hystérésis (3446) est configuré pour, en réponse à la détermination qu'une tension appliquée sur une borne d'entrée négative dudit comparateur à hystérésis (3446) dépasse une tension appliquée sur une borne d'entrée positive dudit comparateur à hystérésis (3446) plus un seuil d'hystérésis, régler une première borne de sortie (OUT) dudit comparateur à hystérésis (3446) sur haut et une deuxième borne de sortie (OUTN) dudit comparateur à hystérésis (3446) sur bas.

4. Système de mesure selon la revendication 3, dans lequel ledit comparateur à hystérésis (3446) comprend :

- un cinquième commutateur électronique (3464) connecté entre ladite entrée négative dudit comparateur à hystérésis (3446) et ladite deuxième borne de sortie (OUTN) dudit comparateur à hystérésis (3446), et
- un sixième commutateur électronique (3466) connecté entre ladite entrée positive dudit comparateur à hystérésis (3446) et ladite première borne de sortie (OUT) dudit comparateur à hystérésis (3446) ;

dans lequel ledit système de mesure est configuré pour :

- au cours d'une phase d'opération normale :

- ouvrir ledit cinquième commutateur électronique (3464) et ledit sixième commutateur électronique (3466).

5. Système de mesure selon une combinaison des revendications 2 et 4, dans lequel ledit système de mesure est configuré pour :

- au cours d'une phase d'opération normale :
- surveiller un signal de requête de réinitialisation (S ; Reset1) indiquant une requête de réinitialisation et démarrer une phase de réinitialisation en réponse à la détermination que ledit signal de requête de réinitialisation indique une requête de réinitialisation ; et
- au cours de ladite phase de réinitialisation :

    - pendant un premier intervalle de réinitialisation ($t_1$-$t_2$), fermer lesdits premier (3448), deuxième (3450), troisième (3452), quatrième (3454), cinquième (3464) et sixième (3466) commutateurs électroniques, et
    - redémarrer ladite phase d'opération normale.

6. Système de mesure selon la revendication 5, dans lequel ledit système de mesure est configuré pour :

- au cours de ladite phase de réinitialisation :
- pendant un deuxième intervalle de réinitialisation ($t_2$-$t_3$) qui suit ledit premier intervalle de réinitialisation ($t_1$-$t_2$), ouvrir lesdits troisième (3452) et quatrième (3454) commutateurs électroniques et maintenir fermés lesdits premier (3448), deuxième (3450), cinquième (3464) et sixième (3466) commutateurs électroniques.

7. Système de mesure selon la revendication 6,

dans lequel ledit intégrateur différentiel est configuré pour recevoir un premier signal de réinitialisation (Reset1), dans lequel ledit troisième commutateur électronique (3452) et ledit quatrième commutateur électronique (3454) sont configurés pour être fermés en réponse à la détermination (3442, 3444) que ledit premier signal de commande ($\Phi_1$) est activé ou que ledit premier signal de réinitialisation (Reset1) est activé ;
dans lequel ledit comparateur à hystérésis (3446) est configuré pour recevoir un deuxième signal de réinitialisation (Reset2), dans lequel ledit cinquième commutateur électronique (3464) et ledit sixième commutateur électronique (3466) sont configurés pour être fermés en réponse à la détermination que ledit deuxième signal de réinitialisation (Reset2) est activé ; et
dans lequel ledit système de mesure est configuré pour, tandis que ledit deuxième signal de commande ($\Phi_2$) est activé :

    - pendant ledit premier intervalle de réinitialisation ($t_1$-$t_2$), activer ledit premier signal de réinitialisation (Reset1) et ledit deuxième signal de réinitialisation (Reset2), et
    - pendant ledit deuxième intervalle de réinitialisation ($t_2$-$t_3$), désactiver ledit premier signal de réinitialisation (Reset1) et activer ledit deuxième signal de réinitialisation (Reset2).

8. Système de mesure selon la revendication 7, comprenant un circuit à retard (3456, 3458) configuré pour générer ledit deuxième signal de réinitialisation (Reset2) en retardant ($t_D$) ledit premier signal de réinitialisation (Reset1) .

9. Système de mesure selon l'une quelconque des revendications 5 à 8 précédentes, dans lequel ledit système de mesure est configuré pour activer ledit signal de requête de réinitialisation après un nombre maximal donné desdits cycles de commutation ($T_S$).

10. Système de mesure selon l'une quelconque des revendications 5 à 9 précédentes, dans lequel ledit système de mesure est configuré pour activer ledit signal de requête de réinitialisation en réponse à la détermination que ladite première borne de sortie (OUT) dudit comparateur à hystérésis (3446) est réglée sur haut et/ou ladite deuxième borne de sortie (OUTN) dudit comparateur à hystérésis (3446) est réglée sur bas.

11. Système de mesure selon l'une quelconque des revendications 3 à 10 précédentes, comprenant un circuit de traitement (44) configuré pour surveiller un signal (S) au niveau de ladite première borne de sortie (OUT) dudit comparateur à hystérésis (3446) et/ou au niveau de ladite deuxième borne de sortie (OUTN) dudit comparateur à hystérésis (3446).

12. Système de mesure selon l'une quelconque des revendications précédentes, dans lequel ledit premier condensateur ($C_1$) correspond à un condensateur de détection (Cs) et ledit deuxième condensateur ($C_2$) correspond à un condensateur de référence ($C_R$) et dans lequel ladite première tension ($V_1$) et ladite deuxième tension ($V_2$) possèdent une tension commune ($V_A$), ce par quoi la tension entre les premier (OUT+) et deuxième (OUT-) noeuds de sortie dudit intégrateur différentiel est indicative de la différence entre les capacités dudit condensateur de détection (Cs) et dudit condensateur de référence ($C_R$).

13. Système de mesure selon la revendication 12, comprenant un générateur de tension (42) configuré pour générer ladite tension commune ($V_A$).

14. Système de mesure selon la revendication 12 ou la revendication 13, comprenant une pluralité de condensateurs de détection ($C_{S1},... C_{SM}$), dans lequel ledit circuit de commutation (32a) comprend, pour chaque condensateur de détection ($C_{S1},... C_{SM}$), un demi-pont respectif, dans lequel chaque demi-pont comprend un commutateur électronique côté haut ($M_{21},... M_{2M}$) connecté entre ladite tension commune ($V_A$) et une première borne ($T_1$) du condensateur de détection ($C_{S1},... C_{SM}$) respectif, et un commutateur électronique côté bas ($M_{41},... M_{4M}$) connecté entre ladite tension de référence ($V_{ref}$) et la première borne ($T_1$) du condensateur de détection ($C_{S1},... C_{SM}$) respectif, et dans lequel ledit circuit de commutation (32a) comprend :

- pour chaque condensateur de détection ($C_{S1},... C_{SM}$), un commutateur électronique ($SW_1,... SW_M$) respectif configuré pour connecter de manière sélective une deuxième borne ($T_2$) de la capacité de détection ($C_{S1},... C_{SM}$) respective à ladite entrée inverseuse dudit amplificateur opérationnel différentiel (3440) ; et/ou
- pour chaque condensateur de détection ($C_{S1},... C_{SM}$), un commutateur électronique ($SW_{11},... SW_{1M}$) respectif configuré pour connecter de manière sélective une borne de commande du commutateur électronique côté haut ($M_{21},... M_{2M}$) respectif audit premier signal de commande ($\Phi_1$) ou à une tension (VDD) conçue pour maintenir ouvert le commutateur électronique côté haut ($M_{21},... M_{2M}$) respectif et un commutateur électronique ($SW_{21},... SW_{2M}$) respectif configuré pour connecter de manière sélective une borne de commande du commutateur électronique côté bas ($M_{41},... M_{4M}$) respectif audit deuxième signal de commande ($\Phi_2$) ou à une tension (GND) conçue pour maintenir ouvert le commutateur électronique côté bas ($M_{41},... M_{4M}$) respectif.

15. Système de mesure selon la revendication 14, comprenant un unique condensateur de référence ($C_R$), dans lequel ledit circuit de commutation (32a) comprend un demi-pont supplémentaire comprenant un commutateur électronique côté haut ($M_1$) supplémentaire connecté entre ladite tension commune ($V_A$) et une première borne ($T_3$) du condensateur de référence ($C_R$), et un commutateur électronique côté bas ($M_3$) supplémentaire connecté entre ladite tension de référence ($V_{ref}$) et la première borne ($T_4$) dudit condensateur de référence ($C_R$).

16. Système de mesure selon la revendication 14, comprenant, pour chaque condensateur de détection ($C_{S1},... C_{SM}$), un condensateur de référence ($C_{R1},... C_{RM}$) respectif, dans lequel une première borne de chaque condensateur de référence ($C_{R1},... C_{RM}$) est connectée à la première borne du condensateur de détection ($C_{S1},... C_{SM}$) respectif.

17. Système de mesure selon l'une quelconque des revendications 1 à 11 précédentes, dans lequel ledit premier condensateur ($C_1$) et ledit deuxième condensateur ($C_2$) possèdent la même valeur de capacité ($C_S$), ce par quoi la tension entre les premier (OUT+) et deuxième (OUT-) noeuds de sortie dudit intégrateur différentiel est indicative de la différence entre ladite première tension ($V_1$ ; $V_{in+}$) et ladite deuxième tension ($V_2$ ; $V_{in-}$).

18. Circuit intégré (40) comprenant un système de mesure selon l'une quelconque des revendications précédentes.

19. Procédé de fonctionnement d'un système de mesure selon l'une quelconque des revendications 1 à 17 précédentes, comprenant :

- au cours d'une phase d'opération normale :

- la fermeture dudit premier commutateur électronique (3448) et dudit deuxième commutateur électronique (3450) en réponse à la détermination que ledit deuxième signal de commande ($\Phi_2$) est activé, et l'ouverture dudit premier commutateur électronique (3448) et dudit deuxième commutateur électronique (3450) en réponse à la détermination que ledit deuxième signal de commande ($\Phi_2$) est désactivé,
- la fermeture dudit troisième commutateur électronique (3452) et dudit quatrième commutateur électronique (3454) en réponse à la détermination que ledit premier signal de commande ($\Phi_1$) est activé, et l'ouverture dudit troisième commutateur électronique (3452) et dudit quatrième commutateur électronique (3454) en réponse à la détermination que ledit premier signal de commande ($\Phi_1$) est désactivé.

20. Procédé selon la revendication 19, comprenant :

- au cours de ladite phase d'opération normale :

- l'ouverture dudit cinquième commutateur électronique (3464) et dudit sixième commutateur électronique (3466), et

- la surveillance d'un signal de requête de réinitialisation (S ; Reset1) indiquant une requête de réinitialisation et le démarrage d'une phase de réinitialisation en réponse à la détermination que ledit signal de requête de réinitialisation indique une requête de réinitialisation ;
- au cours de ladite phase de réinitialisation :

  - pendant un premier intervalle de réinitialisation ($t_1$-$t_2$), la fermeture desdits premier (3448), deuxième (3450), troisième (3452), quatrième (3454), cinquième (3464) et sixième (3466) commutateurs électroniques, et
  - le redémarrage de ladite phase d'opération normale.

# FIG. 1

# FIG. 2

# FIG. 3

FIG. 4

EP 4 339 628 B1

FIG. 5

FIG. 6

FIG. 7

FIG. 8A

FIG. 8B

FIG. 8C

EP 4 339 628 B1

FIG. 9

# FIG. 10

# FIG. 11

# FIG. 12

# FIG. 13

# FIG. 14

## REFERENCES CITED IN THE DESCRIPTION

**Patent documents cited in the description**

- US 20030218473 A1

**Non-patent literature cited in the description**

- **JAMES C. CHEN ; BRUCE W. MCGAUGHY ; DENNIS SYLVESTER ; CHENMING HU.** An On-Chip, Attofarad Interconnect Charge-Based Capacitance Measurement (CBCM) Technique. *International Electron Devices Meeting (IEDM),* 1996
- **NABOVATI.** Novel DC-input [Sigma] [Delta] capacitance-to-digital convertor for biosensor appl. *IEEE 2014 NEWCAS conf.,* 89-92
- **SAGHI FOROUHI ; RASOUL DEHGHANI ; EBRAHIM GHAFAR-ZADEH.** Toward High Throughput Core-CBCM CMOS Capacitive Sensors for Life Science Applications: A Novel Current Mode for High Dynamic Range Circuitry. *Sensors,* 2018